# EUROPEAN PATENT SPECIFICATION

(11) **EP 0 973 181 B1**
(45) Date of publication and mention of the grant of the patent: **09.10.2002**
(21) Application number: 99113723.3
(22) Date of filing: 13.07.1999
(51) Int. Cl.: H01G 9/20, H01M 6/16, H01M 10/40

(54) **Photoelectric conversion device and photoelectrochemical cell**
Photozelle und photoelektrochemische Zelle
Dispositif de conversion photoélectrique et cellule photoélectrochimique

(30) Priority: 17.07.1998 JP 21977798; 21.09.1998 JP 28600698
(43) Date of publication of application: 19.01.2000
(73) Proprietor: FUJI PHOTO FILM CO., LTD., Kanagawa (JP)
(72) Inventor: Hiroo, Takizawa, Minami-Ashigara-shi, Kanagawa (JP)
(74) Representative: Solf, Alexander, Dr.

(56) References cited:
- EP-A- 0 462 935
- WO-A-97/44842
- US-A- 5 294 502
- PATENT ABSTRACTS OF JAPAN vol. 1998, no. 06, 30 April 1998 (1998-04-30) & JP 10 055820 A (KAO CORP), 24 February 1998 (1998-02-24)
- DATABASE INSPEC [Online] INSTITUTE OF ELECTRICAL ENGINEERS, STEVENAGE, GB GRATZEL M: "Titanium dioxide solar cells" Database accession no. 4606838 XP002118483 & SCHWEIZERISCHE TECHNISCHE ZEITSCHRIFT, 15 DEC. 1993, SWITZERLAND, vol. 90, no. 12, pages 32-33, 35, XP002118375 ISSN: 0040-151X
- N. PAPAGEORGIOU, Y. ATHANASSOV, M. ARMAND, P. BONH TE, H. PETTERSSON, A. AZAM, M. GRÄTZEL: "The Performance and Stability of Ambient Temperature Molten Salts for Solar Cell Applications" J. ELECTROCHEM. SOC., vol. 143, no. 10, October 1996 (1996-10), pages 3099-3108, XP002118482
- PATENT ABSTRACTS OF JAPAN vol. 011, no. 070 (E-485), 3 March 1987 (1987-03-03) & JP 61 227377 A (SHOWA DENKO KK;OTHERS: 01), 9 October 1986 (1986-10-09)
- PATENT ABSTRACTS OF JAPAN vol. 1998, no. 12, 31 October 1998 (1998-10-31) & JP 10 189040 A (MITSUI CHEM INC), 21 July 1998 (1998-07-21)
- PATENT ABSTRACTS OF JAPAN vol. 1998, no. 12, 31 October 1998 (1998-10-31) & JP 10 189039 A (MITSUI CHEM INC), 21 July 1998 (1998-07-21)

## Description

### FIELD OF THE INVENTION

This invention relates to a photoelectric conversion device comprising an electrolyte and a semiconductor, and a photo-electrochemical cell comprising the photoelectric conversion device.

### BACKGROUND OF THE INVENTION

Study of sunlight-power generation has been directed chiefly to development of monocrystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, *Nature,* vol. 353, pp. 737-740 (1991) and U.S. Patent 4,927,721 disclosed a photoelectric conversion device using dye-sensitized semiconductor particles, a photo-electrochemical cell comprising the device, and materials and techniques for preparing the same. The proposed cell comprises a work electrode serving as a negative electrode which is composed of an electrically conductive substrate and a porous thin film of titanium dioxide spectrally sensitized with a ruthenium complex (photosensitive layer), a charge transporting layer, and a counter electrode. The charge transporting layer is made of a redox system serving for charge transport between the negative electrode and the counter electrode, i.e., a positive electrode. The photo-electrochemical cell disclosed in the U.S. Patent is a wet type solar cell using an aqueous solution containing an electrolyte salt, such as potassium iodide, (i.e., an electrolytic solution) as a charge transporting layer. This system is promising in that a high energy conversion efficiency can be attained at a low cost. However, because the hole transporting layer comprises an electrolyte solution containing a low-boiling solvent in a large proportion, such as a potassium iodide aqueous solution, there is a fear that the cell will be short of the electrolytic solution due to evaporation in long-term use to have a seriously deteriorated photoelectric conversion efficiency or fail to function as a device.

To solve this problem, JP-A-9-27352 teaches a photo-electrochemical cell having a solid electrolyte comprising crosslinked polyethylene oxide, and *J. Phys. Chem*., vol. 99, pp. 1701-1703 (1995) proposes a photo-electrochemical cell using polyacrylonitrile based polymer gel electrolyte. As a result of studies, however, the photo-electrochemical cells using these solid electrolytes have turned out to have poor photoelectric (conversion) characteristics, especially a low short circuit current density, and insufficient durability.

From WO-A-97 44 842, there are known electrolytes for batteries which contain trialkylphosphates as a solvent.

### SUMMARY OF THE INVENTION

An object of the invention is to provide a photoelectric conversion device and a photo-electrochemical cell excellent in photoelectric (conversion) characteristics and durability.

The above object is accomplished by:

(1) A photoelectric conversion device comprising a semiconductor, an electrically conductive substrate, a counter electrode and an electrolyte containing as a solvent at least one compound selected from a compound represented by formula (I): 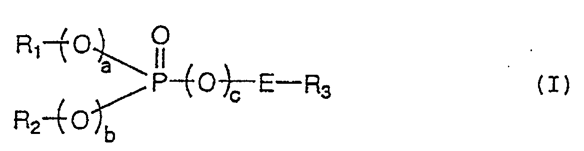 wherein R₁ and R₂, which may be the same or different, each represent an alkyl group, an alkenyl group or an aryl group; R³ represents a cyano group, an alkoxycarbonyl group, an acyloxy group, a carbonamido group, a phosphoric acid group, a phosphono group, a phosphino group, a phosphoryl group, a carbamoyl group, a urethane group, a urea group, a carbonate group, a sulfonamido group, a sulfamoyl group, a sulfoxide group, sulfone group, a sulfonyl group, a nitro group, an alkoxy group, an aryloxy group or a hydroxyl group; E represents a single bond, an alkylene group, an alkenylene group or an arylene group; and a, b, and c each represent 0 or 1, and a compound represented by formula (II):

R₄-D-E-R₃ (II)

wherein R³ and E are as defined above; R⁴ represents a heterocyclic group or an alkyl, alkenyl or aryl group having a heterocyclic group; and D represents -O-, -OC(O)- or -OC(O)O-; and

(2) A photo-electrochemical cell comprising a photoelectric conversion device which comprises a semiconductor, an electrically conductive substrate, a counter electrode and an electrolyte containing as a solvent at least one compound selected from a compound represented by formula (I): 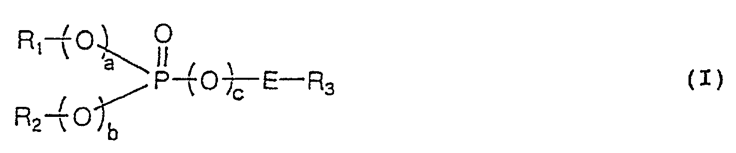 wherein R₁ and R₂, which may be the same or different, each represent an alkyl group, an alkenyl group or an aryl group; R³ represents a cyano group, an alkoxycarbonyl group, an acyloxy group, a carbonamido group, a phosphoric acid group, a phosphono group, a phosphino group, a phosphoryl group, a carbamoy group, a urethane group, a urea group, a carbonate group, a sulfonamido group, a sulfamoyl group, a sulfoxide group, a sulfone group, a sulfonyl group, a nitro group, an alkoxy group, an aryloxy group or a hydroxyl group; E represents a single bond, an alkylene group, an alkenylene group or an arylene group; and a, b, and c each represent 0 or 1, and a compound represented by formula (II):

R₄-D-E-R₃ (II)

wherein R³ and E are as defined above; R⁴ represents a heterocyclic group or an alkyl, alkenyl or aryl group having a heterocyclic group; and D represents -O-, -OC(O)- or -OC(O)O-.

### BRIEF DESCRIPTION OF THE DRAWING

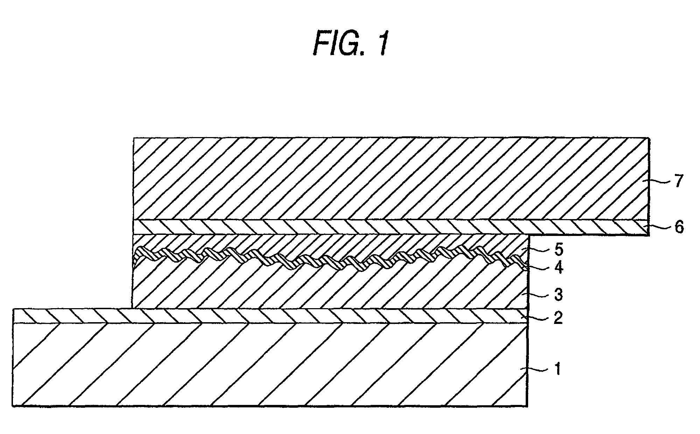

Fig. 1 is a schematic cross section of the photo-electrochemical cell prepared in Examples.

### DETAILED DESCRIPTION OF THE INVENTION

The electrolyte [including a solid electrolyte and a liquid electrolyte (i.e., electrolytic solution)] used in the device or the cell according to the present invention contains a compound represented by formula (I) (hereinafter simply referred to a compound (I)) and/or a compound represented by formula (II) (hereinafter simply referred to as a compound (II)) as a solvent. It is preferred for the electrolyte to contain a polymer. It is still preferred that the electrolyte containing the polymer be a gel electrolyte.

While applicable to a variety of battery cells, the electrolyte is particularly useful in photoelectric conversion devices using semiconductors, such as CCD cameras, and photo-electrochemical cells. It is particularly suitable for use in photo-electrochemical cells using semiconductors.

The compounds (I) and (II) are high-boiling organic solvents, which, when used in an electrolyte in the above-described applications, provide a photoelectric conversion device with excellent performance, particularly excellent photoelectric characteristics, while preventing deterioration of the performance of element due to evaporation of a solvent. When, in particular, combined with a polymer, the compounds (I) and (II) provide a photo-electrochemical cell which has excellent photoelectric characteristics (e.g., a high short circuit current density) and excellent durability (e.g., freedom from reduction in short circuit current density with time) as compared with one using an electrolyte containing conventional solvents.

From the above viewpoint, it is preferred for the compounds (I) and (II) to have a boiling point of 200°C or higher, particularly 250°C or higher. From the standpoint of photoelectric characteristics, such as a short circuit current density and a conversion efficiency, it is preferred for the compounds (I) and (II) to have a low viscosity and a high dielectric constant. To have a low viscosity leads to an improvement in ion mobility. To have a high dielectric constant brings about an increase in effective carrier concentration.

In formula (I), R₁ and R₂ each independently represent a substituted or unsubstituted and straight-chain or branched alkyl group, which preferably contains 1 to 20 carbon atoms (e.g., methyl, ethyl, propyl, butyl, isopropyl, hexyl, t-octyl, benzyl, 2-ethoxyethyl or 2-butoxyethyl); a substituted or unsubstituted and straight-chain or branched alkenyl group, which preferably contains 2 to 20 carbon atoms (e.g., vinyl or allyl); or a substituted or unsubstituted mono- or polycyclic aryl group, which preferably contains 6 to 20 carbon atoms (e.g., phenyl, 4-methoxyphenyl, 4-cyanophenyl or 1-naphthyl). R₁ and R₂ each preferably represent an alkyl group. They may be the same or different but are preferably the same.

R³ in formulae (I) and (II) represents a cyano group, an alkoxycarbonyl group, an acyloxy group, a carbonamido group, a phosphoric acid group, a phosphono group, a phosphino group, a phosphoryl group, a carbamoyl group, a urethane group, a urea group, a carbonate group, a sulfonamido group, a sulfamoyl group, a sulfoxide group, a sulfone group, a sulfonyl group, a nitro group, an alkoxy group, an aryloxy group or a hydroxyl group; and E in formulae (I) and (II) represents a single bond, an alkylene group, an alkenylene group or an arylene group.

R₃ may have a substituent. The alkylene or alkenylene group as represented by E may be substituted or unsubstituted and be either a straight-chain or a branched chain. The arylene group as E may be monocyclic or polycyclic and may be substituted or unsubstituted.

E is preferably an alkylene group having 1 to 8 carbon atoms, still preferably an unsubstituted alkylene group having 1 to 8 carbon atoms, particularly preferably a methylene group, an ethylene group, a propylene group or a butylene group.

R₃ is preferably a cyano group, an alkoxycarbonyl group, an acyloxy group, a phosphoric acid group, a phosphono group, a phosphino group, a phosphoryl group, a carbonate group, a sulfoxide group, a sulfone group, an alkoxy group or a hydroxyl group, still preferably a cyano group, an alkoxycarbonyl group, an acyloxy group, a phosphoric acid group, a phosphoryl group, a carbonate group or an alkoxy group. A cyano group is the most preferred.

In formula (I), a, b and c each independently represent 0 or 1. It is preferred that a be 1; b be 1; and c be 0.

In formula (II), D represents -O-, -OC(O)- (the direction of bonding is no object) or -OC(O)O-, preferably -OC(O)- or -OC(O)O-, still preferably -OC(O)-.

R₄ in formula (II) represents a heterocyclic group or an alkyl, alkenyl or aryl group having a heterocyclic group; wherein the heterocyclic group may be substituted or unsubstituted and may be monocyclic or polycyclic, the alkyl or alkenyl group may be straight or branched, and the aryl group may be monocyclic or polycyclic. R₄ is preferably an alkyl group containing 1 to 8 carbon atoms and having a heterocyclic group bonded to the terminal carbon atom. The heterocyclic group is preferably a 5- or 6-membered saturated heterocyclic group. Preferred examples of the heterocyclic group as R₄ or as the heterocyclic moiety of R₄ are a tetrahydrofuran ring, a 1,4-dioxane ring, a tetrahydropyran ring, an ethylene carbonate ring, a propylene carbonate ring, an imidazolidinone ring, a pyrrolidone ring, an oxazolidinone ring, and a tetrahydrothiophene ring. Still preferred are a tetrahydrofuran ring, an ethylene carbonate ring, a pyrrolidone ring, and an oxazolidinone ring. A condensed ring composed of these heterocyclic rings is also preferred as R₄.

Of the compounds (I) and (II), the compounds (I) are preferred.

Specific but non-limiting examples of the compounds (I) and (II) are shown below. These compounds can be used either individually or as a combination of two or more thereof.

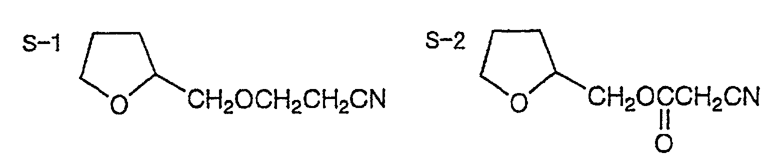

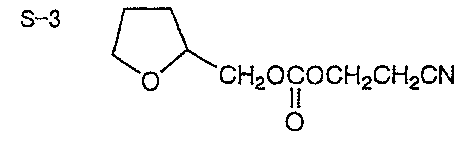

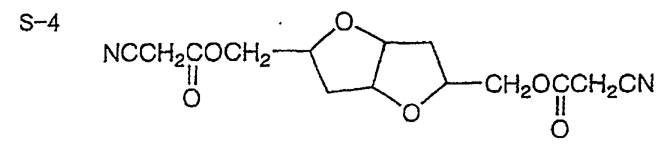

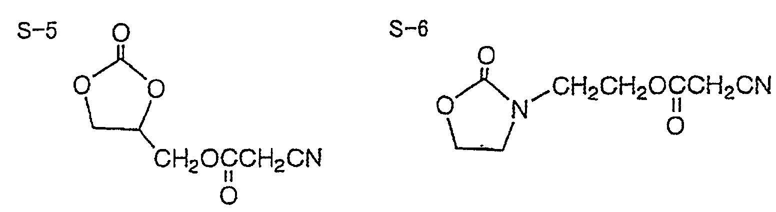

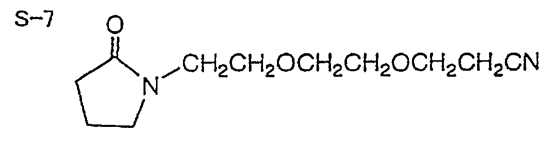

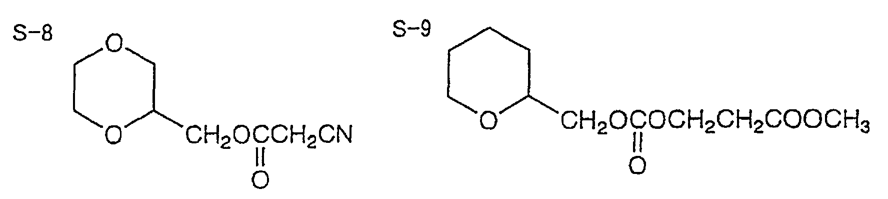

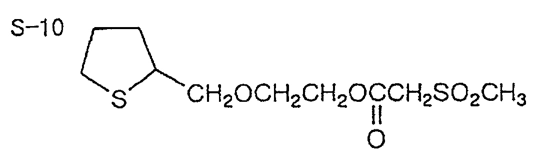

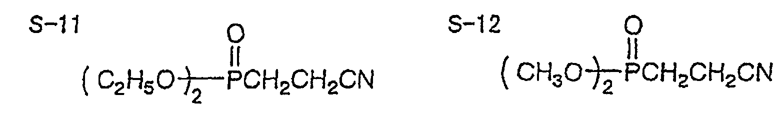

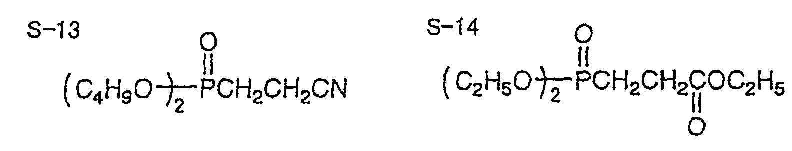

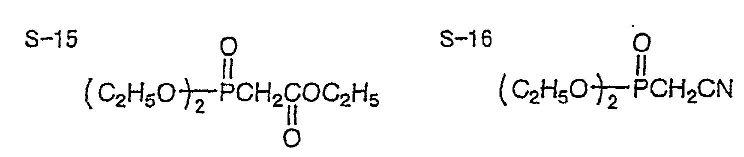

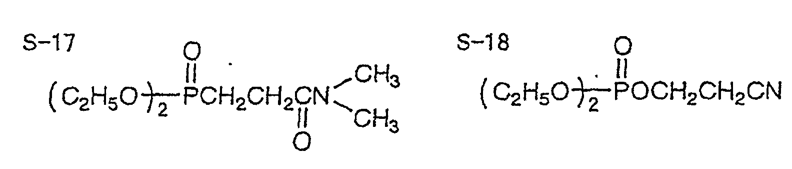

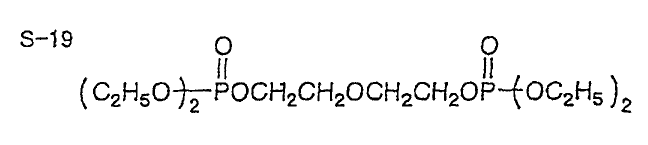

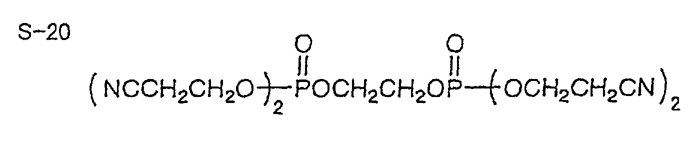

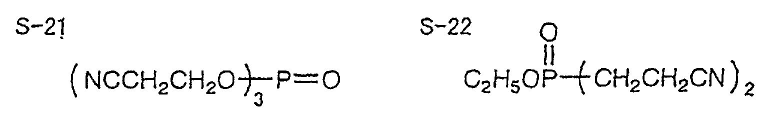

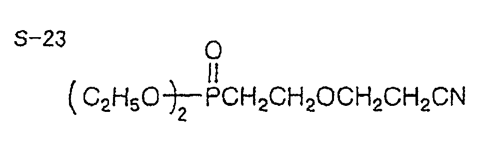

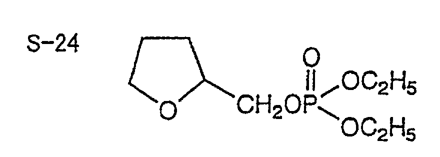

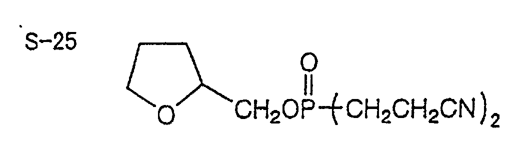

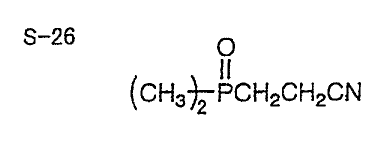

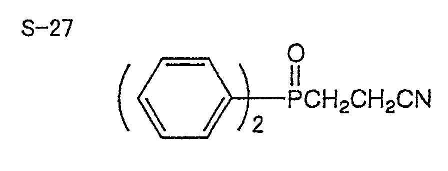

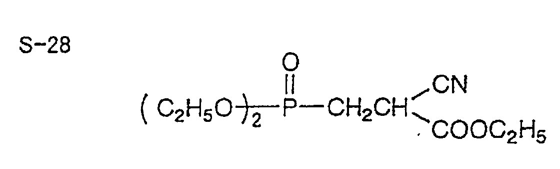

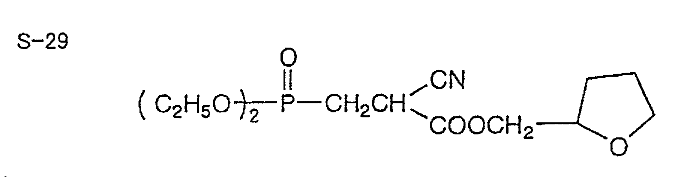

Preferred examples of the polymer which is preferably used in the electrolyte include polyethylene glycol, polyethylene oxide, polypropylene oxide, polyacrylic esters, polymethacrylic esters, polyvinyl alcohol, polyacrylamide, polyallylamine, polyphosphazene, polysilane, polysiloxane, polyvinyl chloride, polyacrylonitrile, polyethylene, polystyrene, polyvinylpyridine, polyvinylimidazole, polypropylene, polyester, polyamide, polyfluoroethylene, and polyvinylidene fluoride, and copolymers comprising two or more of the monomers constituting these homopolymers. Polymers comprising the above-enumerated homo- or copolymer as a main chain and an oxyethylene group, an oxypropylene group, a heterocyclic group, a cyano group, a carbonate group, etc. as a side chain are also preferred.

Still preferred of these main chain structures are polyethylene oxide, polypropylene oxide, polyacrylic esters, polymethacrylic acid esters, polyvinyl alcohol, polyacrylamide, polyallylamine, polysilane, polyacrylonitrile, polystyrene, polyvinylpyridine, polyvinylimidazole, polyfluoroethylene, polyvinylidene fluoride, and their copolymers. Polyacrylonitrile and polyvinylidene fluoride are particularly preferred.

It is desirable that the electrolyte comprising the polymer and the compound (I) and/or (II) be a gel electrolyte from the standpoint of durability and mechanical strength. The term "gel" as used herein means a state of a substance in which colloidal particles or a polymeric molecules lose their independent mobility because of their mutual action and gather to make a solidified structure.

In order for the electrolyte to gel, it is preferred to use polyacrylonitrile or polyvinylidene fluoride as referred to above as a preferred polymer or to use a polymer having a crosslinked structure, i.e., a crosslinked polymer.

The terminology "crosslinked polymer" as used herein is intended to mean a polymer having, as a whole, a three-dimensional network structure formed by crosslinking. Such a crosslinked structure is usually formed by using a crosslinking agent having a polyfunctional group, such as glycerol, methylenebisacrylamide, oligoethylene glycol diacrylates, and alkyl diacrylates. The main chain of the crosslinked polymers preferably includes those described above.

The crosslinked polymer useful in the present invention preferably include those represented by formula (III): 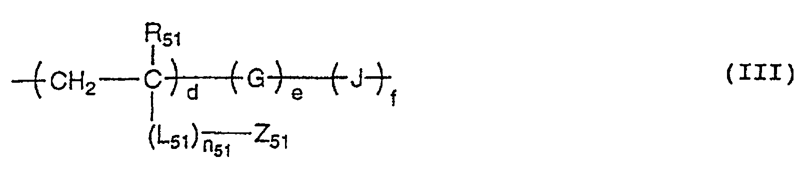 wherein R₅₁ represents a hydrogen atom, an alkyl group or an aryl group; Z₅₁ represents a monovalent organic group having at least one group selected from the group consisting of a heterocyclic group, a cyano group, a carbonate group, -(CH₂CH₂O)ₙ₅₂-R₅₂, and -[CH₂CH(CH₃)O]ₙ₅₃-R₅₃; L₅₁ represents -COO-, -OCO-, -CONR₅₄- or -NR₅₄CO-; n51 represents 0 or 1; R₅₂, R₅₃, and R₅₄ each represent a hydrogen atom, an alkyl group, a cycloalkyl group, an alkenyl group or an aryl group; n52 and n53 each represent an integer of 1 to 30; G represents a repeating unit derived from a compound containing an ethylenically unsaturated group; J represents a repeating unit derived from a compound containing two or more ethylenically unsaturated groups; and d, e, and f represent the weight ratios of the respective repeating units, wherein d is 5 to 99% by weight, e is 0 to 70% by weight, and f is 0.5 to 50% by weight.

In the definition of formula (III), the alkyl or alkenyl group may be substituted or unsubstituted and may be straight or branched, and the aryl group, heterocyclic group or cycloalkyl group may be substituted or unsubstituted and may have a condensed structure.

R₅₁ represents a hydrogen atom, alkyl group (preferably an alkyl group having 1 to 18 carbon atoms, e.g., methyl, ethyl, isopropyl, t-octyl, benzyl, trifluoromethyl or ethoxyethyl) or an aryl group (preferably an aryl group having 6 to 18 carbon atoms, e.g., phenyl, 4-methylphenyl or 2-naphthyl). R₅₁ is preferably a hydrogen atom or a methyl group.

Z₅₁ represents a monovalent organic group containing a heterocyclic group (preferably a heterocyclic group having 1 to 18 carbon atoms, e.g., an ethylene carbonate ring, a propylene carbonate ring, an imdazolidinone ring, a pyrrolidone ring, a succinimide ring, an oxazolidone ring, an imidazole ring or a pyridine ring, still preferably an ethylene carbonate ring, a pyrrolidone ring, an imidazolidinone ring, an oxazolidone ring, an imidazole ring or a pyridine ring), a cyano group, a carbonate group, -(CH₂CH₂O)ₙ₅₂-R₅₂, or -[CH₂CH(CH₃)O]ₙ₅₃-R₅₃ (wherein n52 and n53 each represent an integer of 1 to 30, preferably 1 to 20, still preferably 1 to 10). R₅₂ and R₅₃ each represent a hydrogen atom, an alkyl group (the preference described for the alkyl group as R₅₁ applies), an alkenyl group (preferably an alkenyl group having 2 to 18 carbon atoms, e.g., allyl or vinyl), a cycloalkyl group (preferably a cycloalkyl group having 3 to 18 carbon atoms, e.g., cyclohexyl or cyclopentyl) or an aryl group (the preference described for the aryl group as R₅₁ applies). R₅₂ and R₅₃ each preferably represent a hydrogen atom or an alkyl group having 1 to 8 carbon atoms.

Z₅₁ is preferably one of a heterocyclic group, a cyano group, a carbonate group, -(CH₂CH₂O)ₙ₅₂-R₅₂, and -[CH₂CH(CH₃)O]ₙ₅₃-R₅₃, or a combination of one of them and an alkyl group, an alkyleneoxy group or an aryl group.

L₅₁ represents -COO-, -OCO-, -CONR₅₄- or -NR₅₄CO-, preferably -COO- or -CONR₅₄-, still preferably -COO-. It is preferred that -COO- be bonded to Z₅₁ at the oxygen atom thereof and that -CONR₅₄- be bonded to Z₅₁ at the nitrogen atom thereof. R₅₄ is preferably an alkyl group having 1 to 8 carbon atoms or a hydrogen atom. n51 is 0 or 1.

The proportion d of the repeating unit containing Z₅₁ in the total repeating units of the crosslinked polymer of formula (III) is 5 to 99% by weight, preferably 20 to 95% by weight. Two or more different kinds of the Z₅₁-containing repeating units may be used in combination.

G represents a repeating unit derived from a compound having an ethylenically unsaturated group. Preferred examples of the compounds from which G is derived include esters or amides derived from acrylic acids or α-alkylacrylic acids (e.g., methacrylic acid), such as N-isopropylacrylamide, N-n-butylacrylamide, N-t-butylacrylamide, N,N-dimethylacrylamide, N-methylmethacrylamide, acrylamide, 2-acrylamido-2-methylpropanesulfonic acid, acrylamidopropyltrimethylammonium chloride, methacrylamide, diacetonacrylamide, N-methylolacrylamide, N-methylolmethacrylamide, methyl acrylate, ethyl acrylate, n-propyl acrylate, isopropyl acrylate, 2-methyl-2-nitropropyl acrylate, n-butyl acrylate, isobutyl acrylate, t-butyl acrylate, t-pentyl acrylate, 2,2,2-trifluoroethyl acrylate, 2,2-dimethylbutyl acrylate, 3-methoxybutyl acrylate, ethylcarbitol acrylate, n-pentyl acrylate, 3-pentyl acrylate, octafluoropentyl acrylate, n-hexyl acrylate, cyclohexyl acrylate, cyclopentyl acrylate, cetyl acrylate, benzyl acrylate, n-octyl acrylate, 2-ethylhexyl acrylate, 4-methyl-2-propylpentyl acrylate, heptadecafluorodecyl acrylate, n-octadecyl acrylate, methyl methacrylate, 2,2,2-trifluoroethyl methacrylate, tetrafluoropropyl methacrylate, hexafluoropropyl methacrylate, isobutyl methacrylate, sec-butyl methacrylate, n-octyl methacrylate, benzyl methacrylate, heptadecafluorodecyl methacrylate, n-octadecyl methacrylate, 2-isobornyl methacrylate, 2-norbornylmethyl methacrylate, 5-norbornen-2-ylmethyl methacrylate, 3-methyl-2-norbornylmethyl methacrylate, and dimethylaminoethyl methacrylate; acrylic acid or α-alkylacrylic acids, such as acrylic acid, methacrylic acid and itaconic acid; vinyl esters, such as vinyl acetate; maleic acid, fumaric acid or esters thereof, such as dimethyl maleate, dibutyl maleate, and diethyl fumarate; acrylonitrile, methacrylonitrile; dienes, such as butadiene, cyclopentadiene, and isoprene; aromatic vinyl compounds, such as styrene, p-chlorostyrene, t-butylstyrene, α-methylstyrene, and sodium styrenesulfonate; N-vinylformamide, N-vinyl-N-methylformamide, N-vinylacetamide, N-vinyl-N-methylacetamide, vinylsulfonic acid, sodium vinylsulfonate, sodium allylsulfonate, sodium methallylsulfonate, vinylidene fluoride, vinylidene chloride, vinyl alkyl ethers (e.g., methyl vinyl ether), ethylene, propylene, 1-butene, isobutene, and N-phenylmaleimide. These ethylenically unsaturated compounds can be used either individually or as a combination thereof. Additional examples of useful ethylenically unsaturated compounds are given in *Research Disclosure*, No. 1955 (Jul., 1980). The proportion e of the repeating unit G in the total repeating units of the crosslinked polymer of formula (III) is 0 to 70% by weight, preferably 0 to 50% by weight.

J represents a repeating unit derived from a compound containing two or more ethylenically unsaturated groups per molecule. Examples of preferred compounds containing two or more ethylenically unsaturated groups per molecule include divinylbenzene, 4,4'-isopropylidenediphenylene diacrylate, 1,3-butylene diacrylate, 1,3-butylene dimethacrylate, 1,4-cyclohexylenedimethylene dimethacrylate, diethylene glycol dimethacrylate, diisopropylidene glycol dimethacrylate, divinyloxymethane, ethylene glycol diacrylate, ethylene glycol dimethacrylate, diethylene glycol diacrylate, ethylidene diacrylate, ethylidene dimethacrylate, allyl acrylate, allyl methacrylate, 1,6-diacrylamidohexane, N,N'-methylenebisacrylamide, N,N'-(1,2-dihydroxy)ethylenebisacrylamide, 2,2-dimethyl-1,3-trimethylene dimethacrylate, phenylethylene dimethacrylate, tetraethylene glycol dimethacrylate, tetramethylene diacrylate, tetramethylene dimethacrylate, 2,2,2-trichloroethylidene dimethacrylate, triethylene glycol diacrylate, pentaerythritol triacrylate, trimethylolmethane triacrylate, trimethylolpropane triacrylate, tetramethylolmethane tetraacrylate, trimethylolmethane trimethacrylate, triethylene glycol dimethacrylate, 1,3,5-triacryloylhexahydro-s-triazine, bisacrylamidoacetic acid, ethylidyne trimethacrylate, propylidyne triacrylate, and vinyl allyloxyacetate. Preferred of them are divinylbenzene, ethylene glycol dimethacrylate, ethylene glycol diacrylate, ethylene glycol dimethacrylate, diethylene glycol diacrylate, diethylene glycol dimethacrylate, triethylene glycol diacrylate, and triethylene glycol dimethacrylate. The proportion f of the repeating unit J in the total repeating units of the crosslinked polymer of formula (III) is 0.5 to 50% by weight, preferably 1.0 to 30% by weight.

The polymers which can be used in the electrolyte preferably have a weight average molecular weight of 1000 or more, particularly 2000 or more.

Non-limiting specific examples of the polymer which can be used in the invention are shown below. In the formulae shown, subscript symbol n indicates degree of polymerization, and other subscript symbols, e.g., d, e, and f, represent the weight ratios of the respective units.

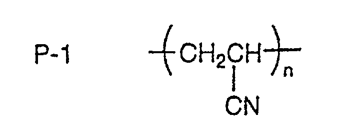

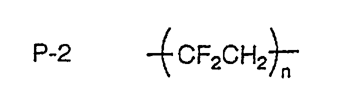

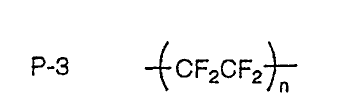

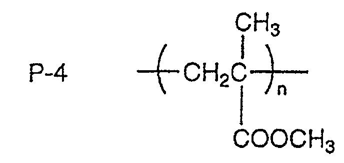

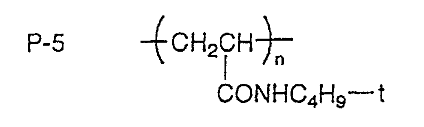

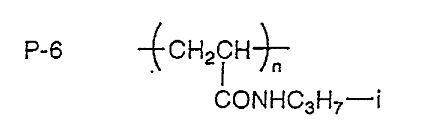

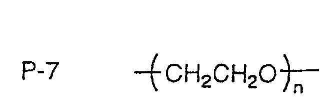

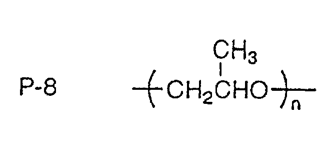

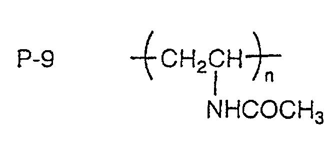

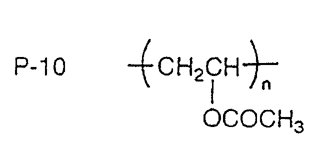

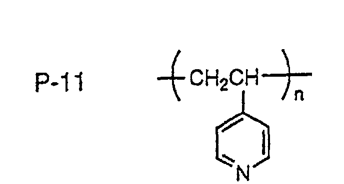

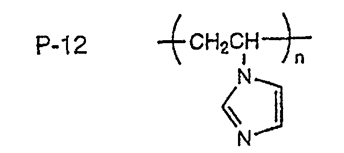

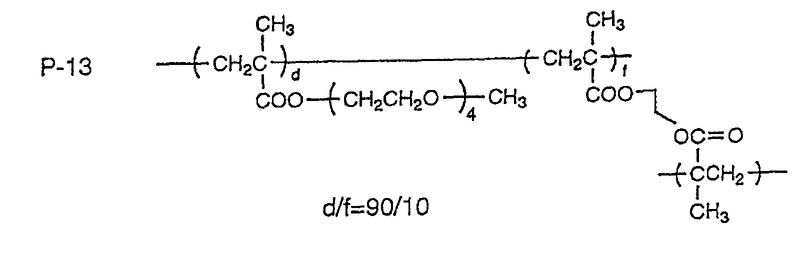

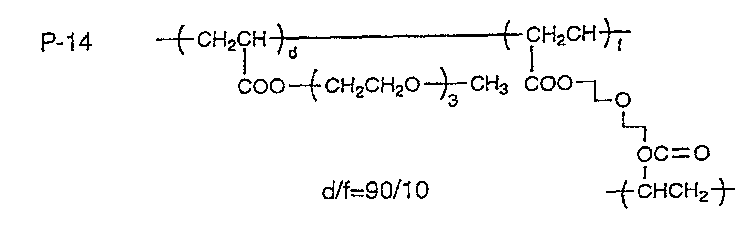

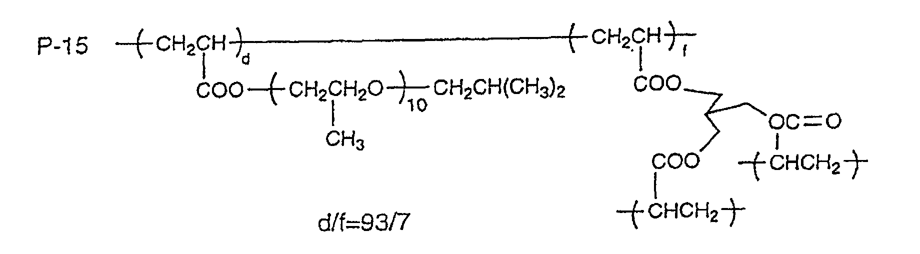

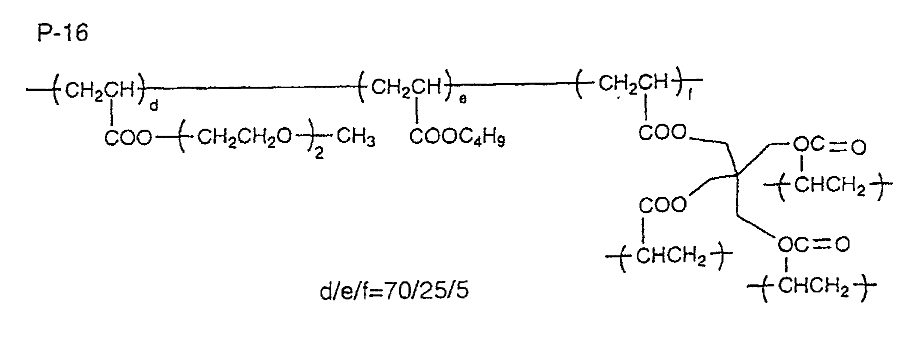

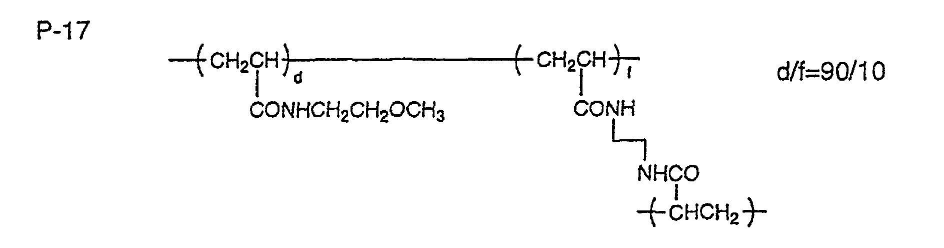

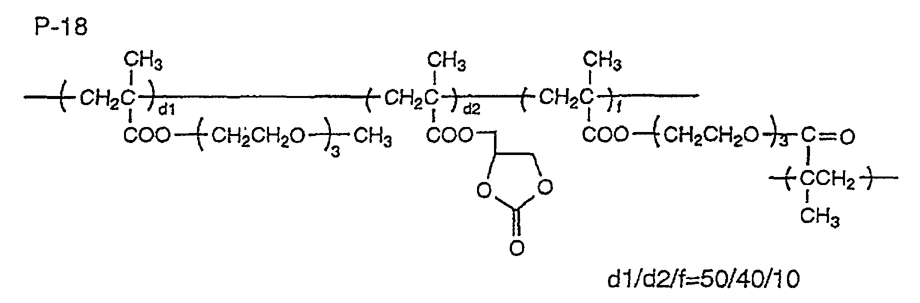

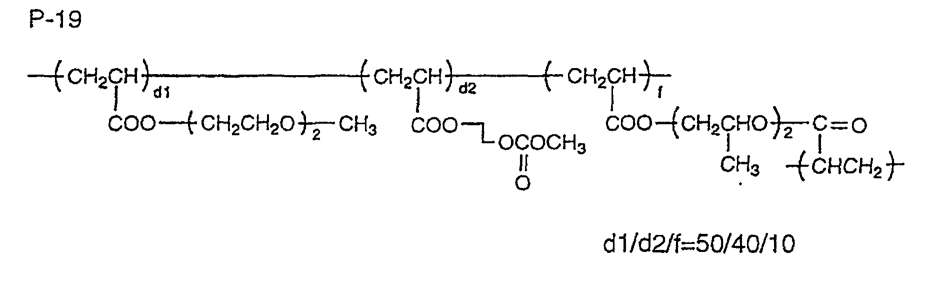

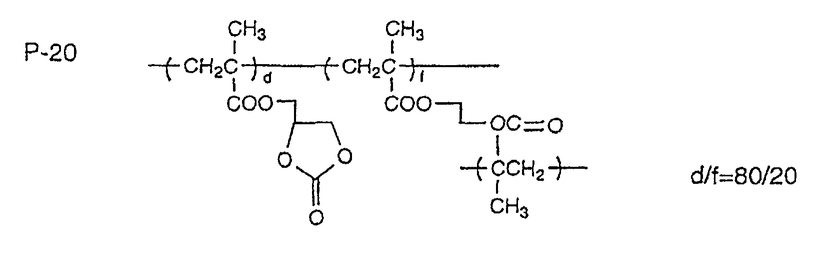

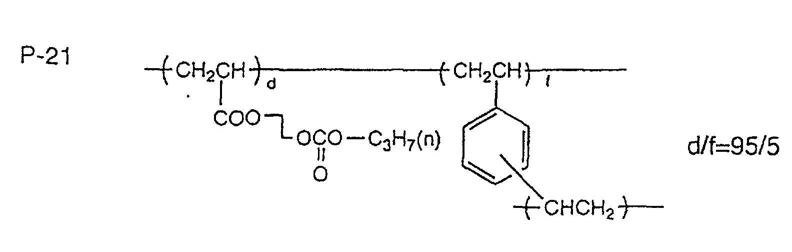

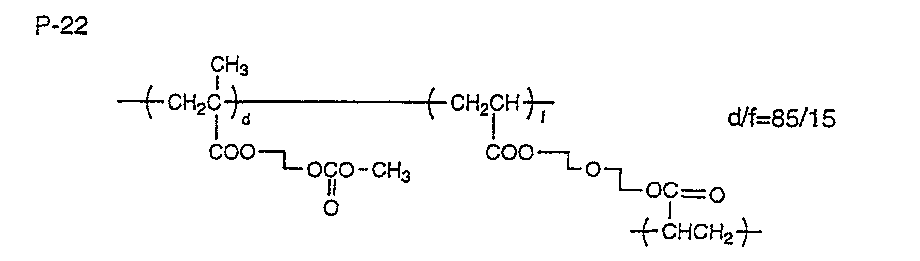

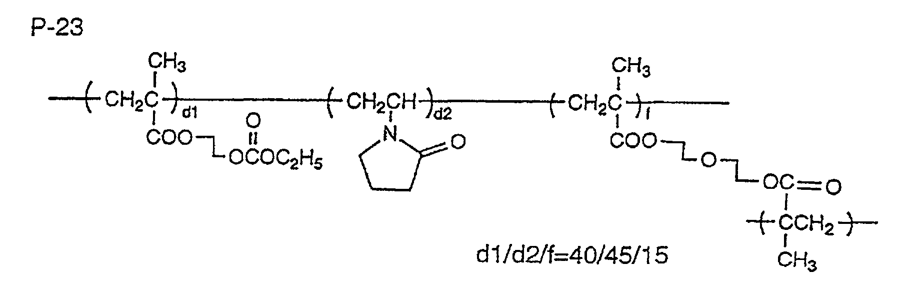

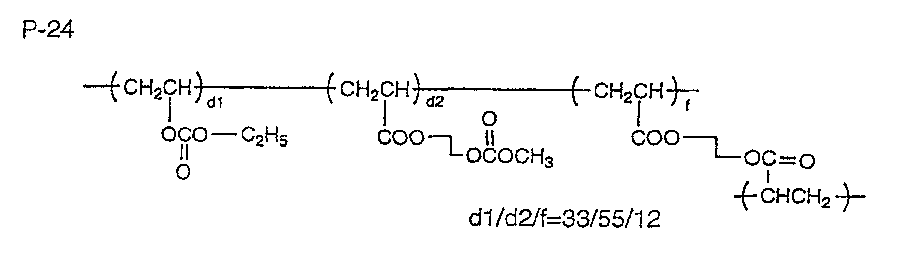

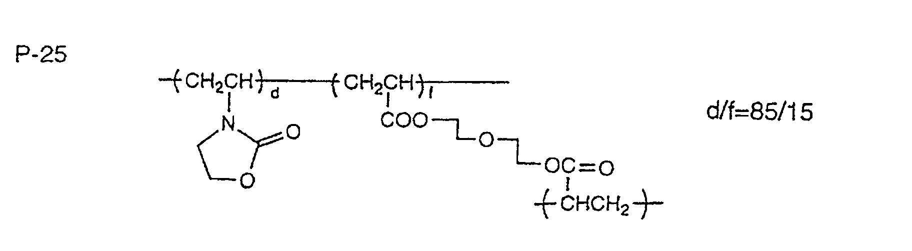

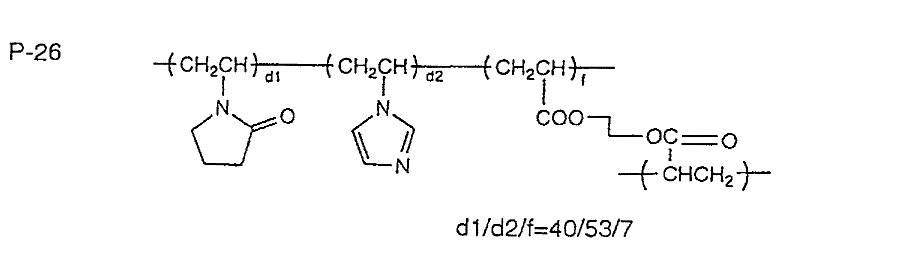

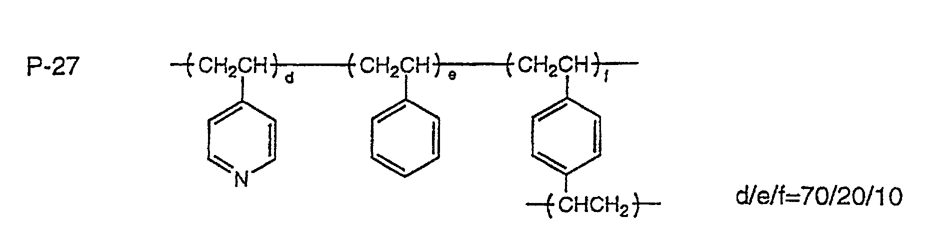

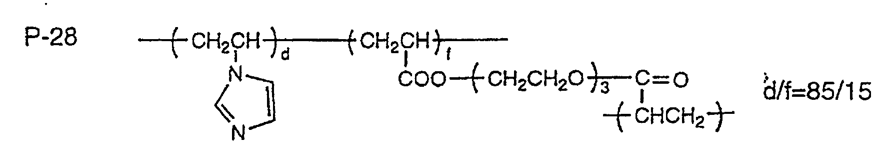

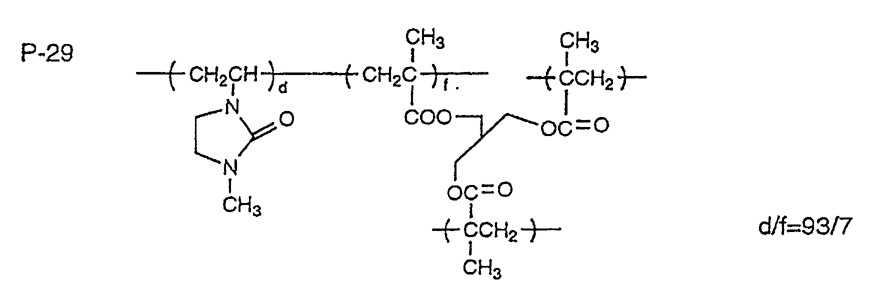

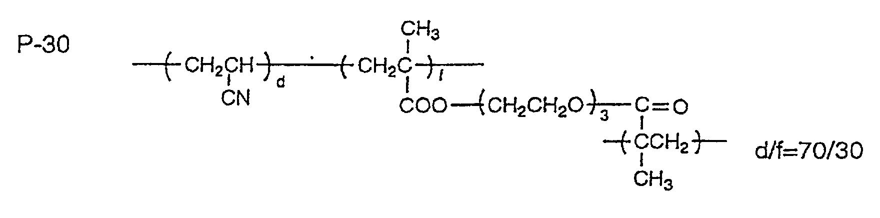

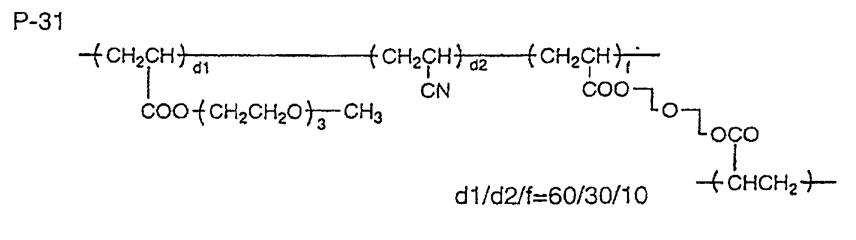

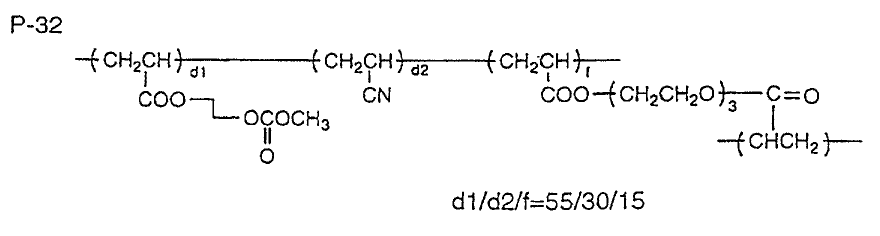

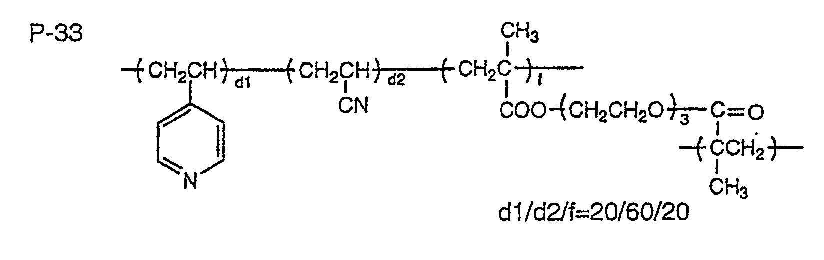

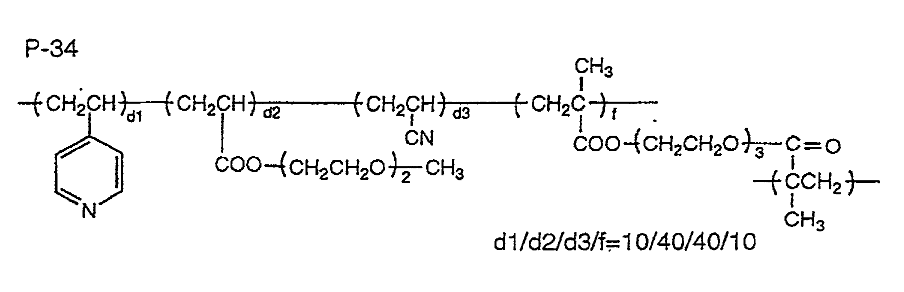

The polymers to be used in the invention are synthesized by radical polymerization that is a general method for polymer synthesis as described in T. Ohtsu and M. Kinoshita, *KOBUNSHI NO JIKKENHO*, Kagaku Dojin or T. Ohtsu, *Kouza Jugou Han-no-ron 1 Radical Polymerization (I)*, Kagaku Dojin. Radical polymerization can be induced by heat, light or electron rays or electrochemically. Heat-induced radical polymerization is preferred. Polymerization initiators preferably used in heat-induced radical polymerization include azo initiators, such as 2,2'-azobisisobutyronitrile, 2,2'-azobis(2,4-dimethylvaleronitrile), dimethyl 2,2'-azobis(2-methylpropionate), and dimethyl 2,2'-azobisisobutyrate; and peroxide initiators, such as lauryl peroxide, benzoyl peroxide, and t-butyl peroctoate. The polymerization initiator is preferably used in an amount of 0.01 to 20% by weight, particularly 0.1 to 10% by weight, based on the total monomers.

To ensure the effects of the invention, the polymer is preferably used in a concentration of 0.02 to 50% by weight, still preferably 0.1 to 30% by weight, particularly preferably 1 to 20% by weight, in the electrolyte. In lower concentrations, gelation tends to be insufficient for securing stability of the performance as a photo-electrochemical cell. In higher concentrations, reduction in initial performance of a photo-electrochemical cell, especially photoelectric current density, can result.

In addition to the compounds (I) and (II) and the above-described polymer, the electrolyte [including a solid electrolyte and a liquid electrolyte (i.e., electrolytic solution)] comprises electrolyte components. Examples of useful electrolyte components include a metal iodide, such as LiI, NaI, KI, CsI or CaI₂; an iodine salt of a quaternary ammonium compound (e.g., an imidazolium compound, a pyridinium compound or a tetraalkylammonium compound); Br₂ and a metal bromide, such as LiBr, NaBr, KBr, CsBr or CaBr₂; Br₂ and a bromine salt of a quaternary ammonium compound, such as a tetraalkylammonium bromide or pyridinium bromide; a metal complex, such as a ferrocyananate-ferricyanate or a ferrocene-ferricinium ion; a sulfur compound, such as poly(sodium sulfite) or an alkylthiol-alkyl disulfide; a viologen dye; hydroquinonequinone, and the like. Preferred of them are a metal iodide, such as LiI, NaI, KI, CsI or CaI₂, an iodine salt of an imidazolium compound, an iodine salt of a pyridinium compound (e.g., pyridinium iodide), and an iodine salt of a tetraalkylammonium compound. The electrolyte component is preferably used in a concentration of 0.05 mol/l of 1.5 mol/l, particularly 0.1 mol/l to 0.8 mol/l. Iodine can be added to the electrolyte to previously form a redox pair. In this case, iodine is preferably added in a concentration of 0.01 to 0.2 mol/l, which will bring about improved effects. As the concentration of the electrolyte component diminishes, the function as an electron carrier tends to be insufficient. Higher concentrations of the electrolyte component than necessary would not bring about further improvement in effect and, moreover, result in reduction of photoelectric current density due to an elevation of viscosity.

The gel electrolyte contains a gelling agent having a molecular weight of 1000 or less. The gelling agent used in the invention is a compound capable of solidifying (gelling) a whole system when added in a concentration of 500 g/l or less in an organic solvent

The term "gel" generally means a state of a substance in which colloidal particles or a polymeric molecules lose their independent mobility because of their mutual action and gather to make a solidified structure. In the present invention, any compound can be used as a gelling agent as long as it has a molecular weight of 1000 or less, usually 100 or more, and is capable of solidifying (gelatinizing) an organic solvent when present in a concentration of 500 g/l or less, usually 0.1 g/l or more. Useful gelling agents include those which undergo self association in a solution to form a gel structure through secondary interaction that is not covalent bonding, such as hydrogen bonding, electrostatic mutual action, coordinate bonding, van der Waals force, and π-π electron mutual action. Compounds known to have such properties, while not at all abundant in kind, include dibenzylidene-D-sorbitol, cholesterol derivatives, amino acid derivatives, alkylamide derivatives of trans-(1R,2R)-1,2-cyclohexanediamine, alkylurea derivatives, N-octyl-D-gluconamide benzoate, twin type amino acid derivatives, and quaternary ammonium salts. For details of these compounds, refer to *J. Chem. Soc*., Japan Ind. Chem. Soc., vol. 46, p. 779 1943), *J. Am. Chem. Soc.,* vol. 111, *p.* 5542 (1989), *J. Chem. Soc*., p. 390 (1993), Chem. Commun., *Angew. Chem. Int. Ed. Engl*., vol. 35, p. 1949 (1996), *Chem*. *Lett.,* p. 885 (1996), and *J. Chem. Soc*., p. 545 (1997), Chem. Commn. In particular, compounds having at least one amido group per molecule are preferred.

Examples of preferred gelling agents for use in the invention are shown below only for illustrative purposes but not for limitation.

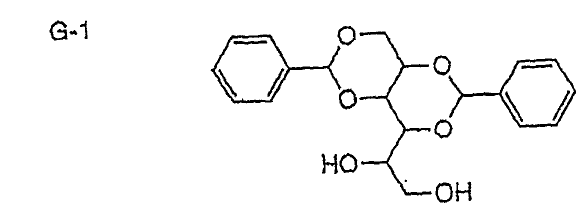

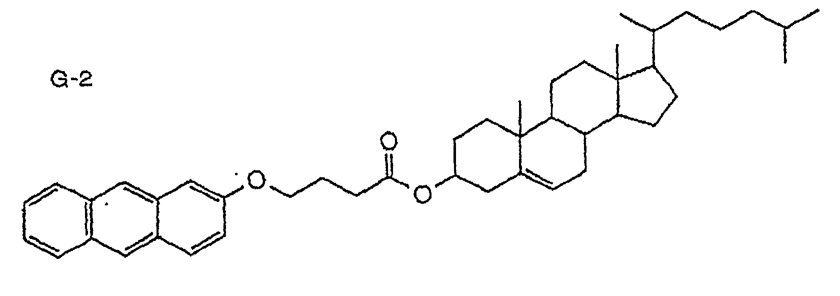

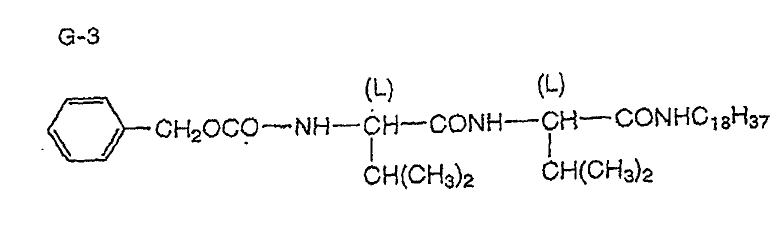

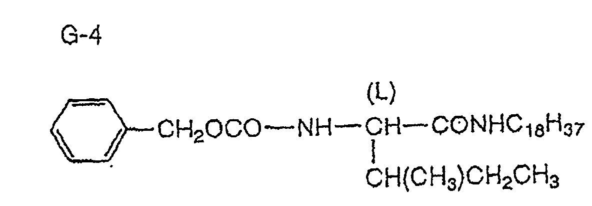

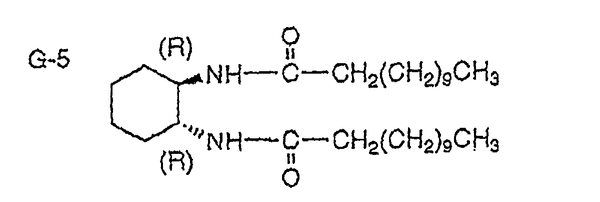

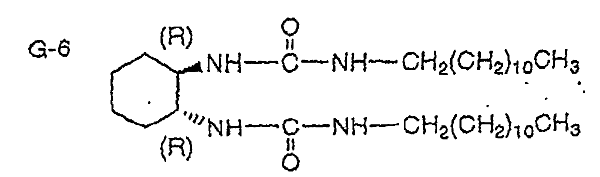

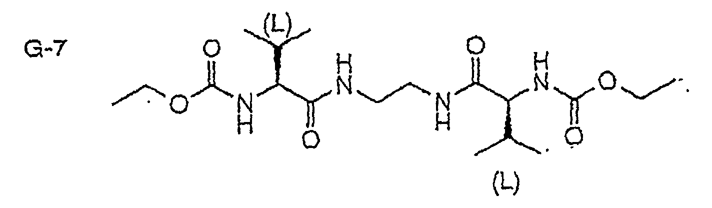

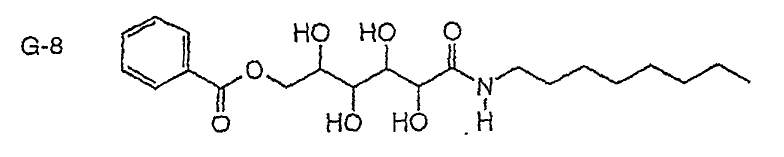

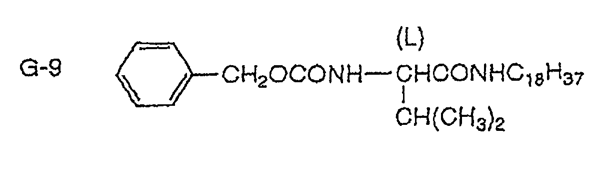

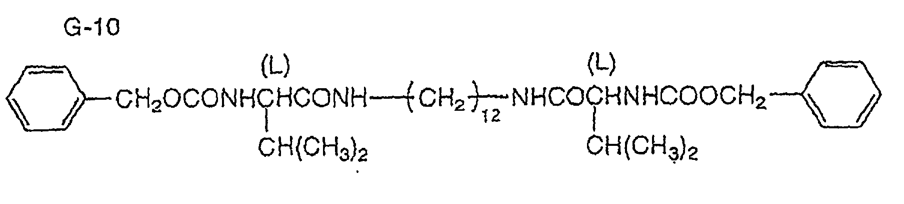

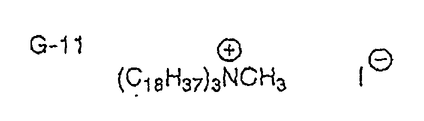

Of the gelling agents shown above particularly preferred are amino acid derivatives G-3, G-4 and G-9 and twin type amino acid derivatives G-7 and G-10.

The gelling agent is preferably present in a gel electrolyte in concentrations of 0.2 to 500 g/l, particularly 0.5 to 300 g/l, to enhance the effects of the invention. In lower concentrations, gelation tends to be insufficient for securing stability of the performance as a photoelectric conversion device. In higher concentrations, reduction in initial performance of a photo-electric conversion device, especially photoelectric current density, can result.

The photo-electrochemical cell according to the present invention comprises a semiconductor responsive to radiations, a charge transporting layer, and a counter electrode. The semiconductor serves as a photoreceptor that absorbs light to generate electrons and positive holes, and the charge transporting layer contains the electrolyte of the invention. The photo-electrochemical cell preferably comprises a photoelectric conversion device composed of an electrically conductive substrate having a semiconductor layer (photosensitive layer) thereon, a charge transporting layer containing the electrolyte of the invention, preferably the gel electrolyte, and a counter electrode.

The charge transporting layer containing the electrolyte preferably has a thickness of 0.001 to 200 µm, particularly 0.1 to 100 µm.

The semiconductor which can be used in the invention includes simple substance semiconductors, e.g., Si or Ge, compound semiconductors, such as metal chalcogenides (e.g., oxides, sulfides, and selenides), and perovskite semiconductors. The metal chalcogenides include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Other compound semiconductors include a phosphide of zinc, potassium, indium or cadmium, gallium arsenide, copper indium selenide, and copper indium sulfide. The perovskite semiconductors include strontium titanate, calcium titanate, sodium titanate, barium titanate, and potassium niobate.

Preferred semiconductors for use in the invention include Si, TiO₂, SnO₂, Fe₂O₃, WO₃, ZnO, Nb₂O₅, CdS, ZnS, Pbs, Bi₂S₃, CdSe, Gap, InP, GaAs, CdTe, CuInS₂, and CuInSe₂. Still preferred are TiO₂, ZnO, SnO₂, Fe₂O₃, WO₃, Nb₂O₅, CdS, PbS, CdSe, InP, GaAs, CuInS₂, and CuInSe₂.

The semiconductor may be a single crystal or polycrystalline. A single crystal is preferred for conversion efficiency, while a polycrystalline semiconductor is preferred from the standpoint of production cost, supply of raw materials, and an energy payback time. Finely particulate semiconductors having a particle size on the order of nanometers to microns are particularly preferred. The particulate semiconductors preferably have an average primary particle size of 5 to 200 nm, particularly 8 to 100 nm, in terms of a projected circle-equivalent diameter. The semiconductor particles in a dispersed state preferably have an average particle size of 0.01 to 100 µm.

It is preferred for the particulate semiconductors, particularly metal oxide semiconductors, to be sensitized with dyes. For example, TiO₂, ZnO, SnO₂, Fe₂O₃, WO₃, and Nb₂O₅ are preferred for semiconductors to be dye-sensitized. TiO₂ is particularly preferred to be dye-sensitized.

The photoelectric conversion devices and photo-electrochemical cells using dye-sensitized semiconductor particles will be illustrated in more detail.

The photoelectric conversion device using dye-sensitized semiconductor particles (hereinafter referred to as a dye-sensitized photoelectric conversion device) is preferably composed of an electrically conductive substrate, a layer of semiconductor particles having adsorbed thereon a dye (a photosensitive layer), the photosensitive layer being provided on the conductive substrate, an electrolyte containing the compound (I) or (II) (preferably the compound (I) or (II) having a boiling point of 200°C or higher, particularly 250°C or higher), and a counter electrode.

The electrically conductive substrate includes a substrate made of a conductive material, such as metal, and a nonconductive substrate made of glass or plastics having on the surface thereof an electrical conductor layer. Preferred conductors for use in the latter type of conductive substrates include metals (e.g., platinum, gold, silver, copper, aluminum, rhodium, and indium), carbon, and electrically conducting metal oxides (e.g., indium-tin composite oxide and F-doped tin oxide). Of the above conductive substrates particularly preferred is a conductive glass substrate obtained by depositing F-doped tin dioxide on a transparent substrate made of inexpensive soda-lime float glass. The conductor layer preferably has a thickness of about 0.02 to 10 µm.

The conductive substrate preferably has as low a surface resistivity as possible. A desirable surface resistivity is 100 Ω/cm² or smaller, particularly 40 Ω/cm² or smaller. While not limiting, the practical minimal surface resistivity is about 0.1 Ω/cm².

It is preferred that the conductive substrate be substantially transparent to light. The term "substantially transparent" means that the light transmission is at least 10%, preferably 50% or more, still preferably 70% or more. A glass or plastic substrate having an electrically conductive metal oxide layer is preferred as a transparent substrate. The amount of the conductive metal oxide is preferably 0.01 to 100 g/m². The transparent conductive substrate is preferably used in such a manner that incident light enters from the side of the glass or plastic substrate.

The semiconductor particles are applied to the conductive substrate by, for example, a method comprising coating the conductive substrate with a dispersion or colloidal solution of the semiconductor particles or a sol-gel process comprising applying a precursor of the semiconductor particles onto the conductive substrate and hydrolyzing the precursor with moisture in air to form a particulate semiconductor film. A dispersion of the semiconductor particles is prepared by the above-mentioned sol-gel process, a method comprising grinding and dispersing a semiconductor in a mortar, or a method comprising wet grinding and dispersing a semiconductor in a mill. A synthetic semiconductor as precipitated in a solvent in the form of fine particles can also be used as such. Useful dispersing media include water and various organic solvents, such as methanol, ethanol, isopropyl alcohol, dichloromethane, acetone, acetonitrile, and ethyl acetate. In preparing a dispersion, a polymer, a surface active agent, an acid, a chelating agent, and the like may be added as a dispersing aid.

It is preferable for the semiconductor particles to have a large surface area so that they may adsorb as large an amount of a dye as possible. The surface area of the semiconductor particles in the state applied to the conductive substrate is preferably 10 times or more, still preferably 100 times or more, the projected area. The upper limit of the surface area is, while not limited, practically about 1000 times the projected area.

In general, as the thickness of the particulate semiconductor layer increases, the amount of the supported dye per unit projected area increases to show increased ability of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. Where the device is used in a photo-electrochemical cell, the thickness is preferably 1 to 30 µm, still preferably 3 to 20 µm. It is preferred that the semiconductor particles applied to the substrate be calcined so that the particles may be brought into electronic contact among themselves to secure improved film strength and improved adhesion to the substrate. A preferred calcined temperature is 40°C or higher and lower than 700°C, particularly from 40 to 650°C. The calcining time is usually from 10 minutes to about 10 hours. For the purpose of increasing the surface area of the semiconductor particles and of increasing the purity in the vicinities of the semiconductor particles thereby to improve electron injection efficiency from the dye to the semiconductor particles, the calcined particulate semiconductor layer can be subjected to chemical plating with a titanium tetrachloride aqueous solution or electrochemical plating with a titanium trichloride aqueous solution.

The amount of the semiconductor particles to be applied is preferably 0.5 to 500 g/m², still preferably 5 to 100 g/m².

The dye which can be used in the present invention preferably includes metal complex dyes and/or polymethine dyes. It is preferred for the dye to have an appropriate interlocking group for linking to the surface of the semiconductor particles. Preferred interlocking groups include -COOH, -SO₃H, a cyano group, -P(O)(OH)₂, -OP(O)(OH)₂, and chelating groups having pi conductivity, such as oxime, dioxime, hydroxyquinoline, salicylate and α-keto-enolate groups. Particularly preferred of them are -COOH, -P(O)(OH)₂, and -OP(O)(OH)₂. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can be used as a interlocking group.

The metal complex dyes preferably include ruthenium complex dyes. Those represented by formula (IV) are still preferred.

(Y₁)ₚRuBₐB_{b}B_{c} (IV)

wherein Y₁ represents a ligand selected from the group consisting of Cl, SCN, H₂O, Br, I, CN, -NCO and SeCN; p represents an integer of 0 to 2 (preferably 2); and Bₐ, B_{b}, and B_{c} each represent an organic ligand selected from B-1 to B-8 shown below. 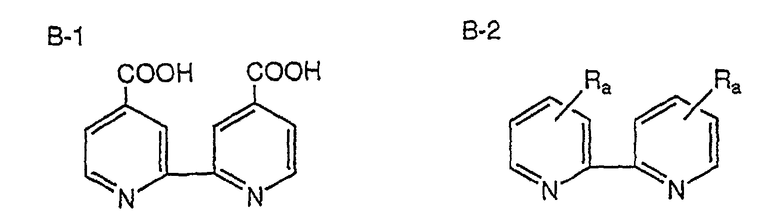 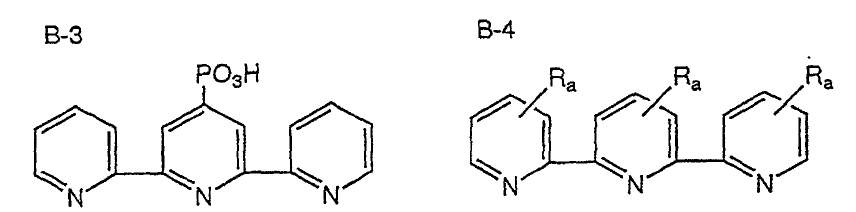 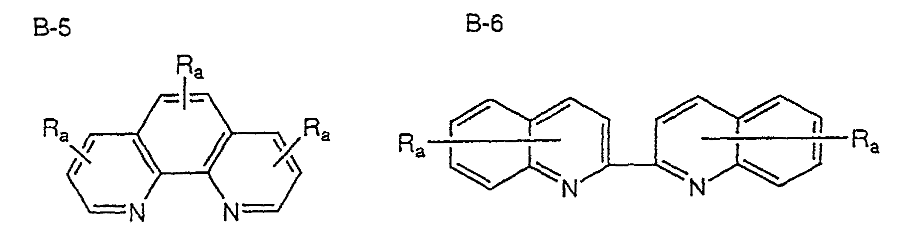 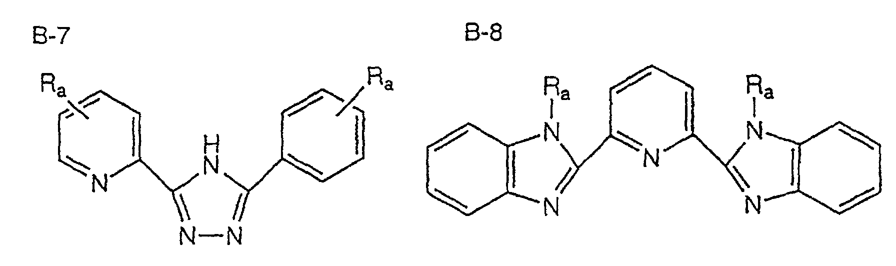 wherein Rₐ represents a hydrogen atom, a halogen atom, a substituted or unsubstituted alkyl group having 1 to 12 carbon atoms, a substituted or unsubstituted aralkyl group having 7 to 12 carbon atoms or a substituted or unsubstituted aryl group having 6 to 12 carbon atoms. The alkyl group and the alkyl moiety of the aralkyl group may be either straight or branched, and the aryl group and the aryl moiety of the aralkyl group may be either monocyclic or polycyclic (a condensed ring).

The ruthenium complex dyes useful in the present invention include those described in U.S. Patents 4,927,721, 4,684,537, 5,084,365, 5,350,644, 5,463,057, and 5,525,440 and JP-A-7-249790. Specific examples of the ruthenium complex dyes represented by formula (IV) are tabulated below.

**TABLE 1**

| No. | Y₁ | p | Bₐ | B_{b} | B_{c} | Rₐ |
|---|---|---|---|---|---|---|
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | Br | 2 | B-1 | B-1 | - | - |
| R-5 | I | 2 | B-1 | B-1 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 2 | B-1 | B-6 | - | H |
| R-11 | CN | 2 | B-1 | B-7 | - | H |
| R-12 | Cl | 1 | B-1 | B-8 | - | H |
| R-13 | - | 0 | B-1 | B-1 | B-1 | - |

Specific examples of other suitable metal complex dyes are shown below.

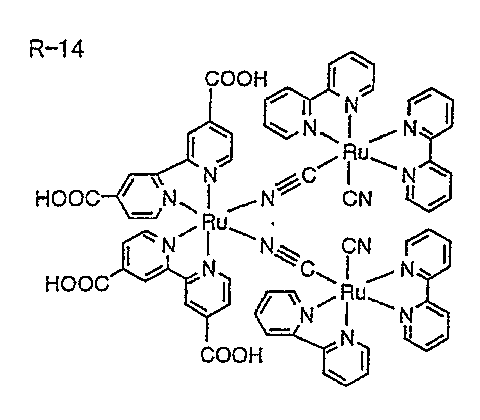

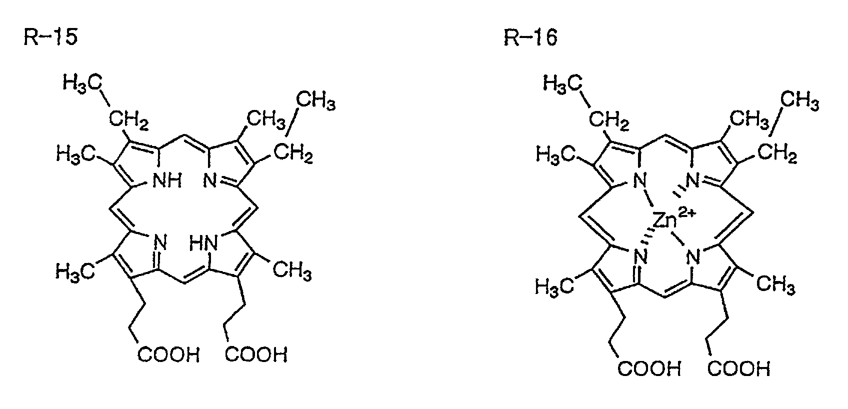

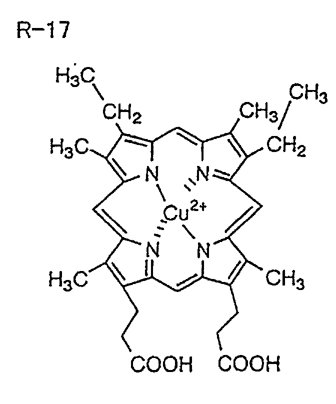

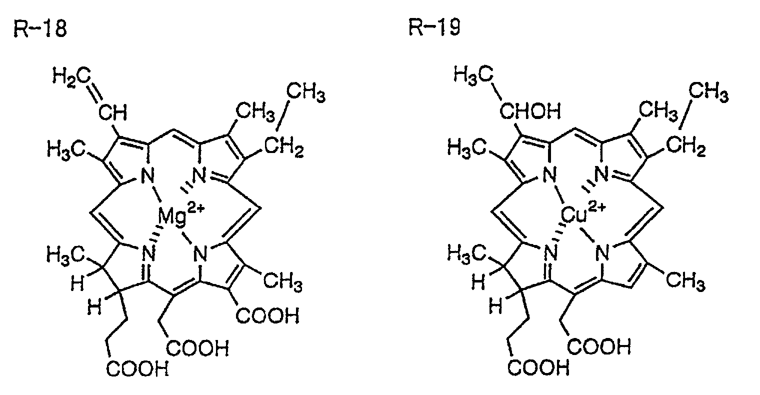

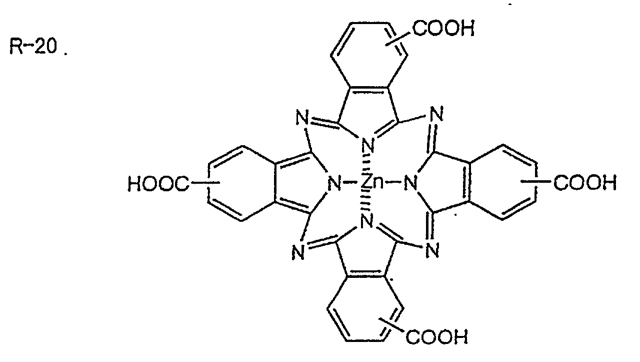

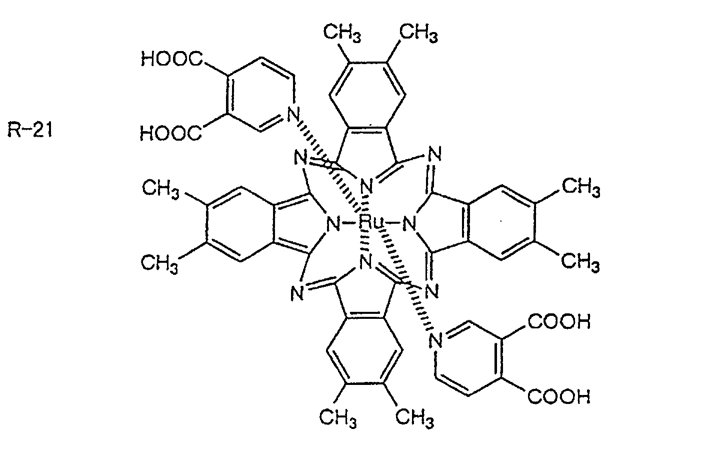

The polymethine dyes preferably include those represented by formulae (V) and (VI) shown below. 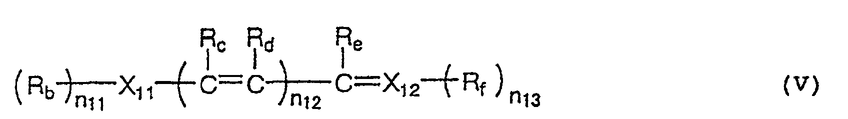 wherein R_{b} and R_{f} each represent a hydrogen atom, an alkyl group, an aryl group or a heterocyclic group; R_{c}, R_{d}, and Rₑ each represent a hydrogen atom or a substituent; R_{b}, R_{c}, R_{d}, Rₑ, and R_{f} may appropriately be taken together to form a ring; X₁₁ and X₁₂ each represent a nitrogen atom, an oxygen atom, a sulfur atom, a selenium atom or a tellurium atom; n11 and n13 each represent an integer of 0 to 2; and n12 represents an integer of 1 to 6.

The compound of formula (V) may have a counter ion in agreement with the charge quantity of the whole molecule. In formula (V), the alkyl, aryl, and heterocyclic groups may have a substituent; the alkyl group may be straight or branched; the aryl and heterocyclic groups may be monocyclic or polycyclic (a condensed ring); and the ring formed of R_{b}, R_{c}, R_{d}, Rₑ, and R_{f} may have a substituent and may be monocyclic or polycyclic. 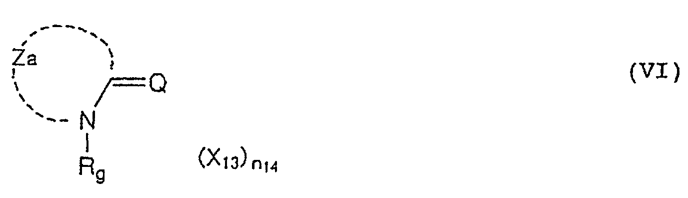 wherein Zₐ represents a non-metal atomic group necessary to form a nitrogen-containing heterocyclic group; R_{g} represents an alkyl group or an aryl group; Q represents a mono- or polymethine group necessary to complete a (poly)methine dye; X₁₃ represents a counter ion in balance; and n14 represents a number of from 0 up to 10 that is necessary to neutralize the charge of the molecule.

In formula (VI), the nitrogen-containing heterocyclic ring formed by Za may have a substitutent and may be a single ring or a condensed ring; the alkyl or aryl groups may have a substituent; the alkyl group may be straight or branched; and the aryl group may be monocyclic or polycyclic (a condensed ring).

The dye represented by formula (VI) preferably includes those represented by formulae (VII-a) through (VII-d): 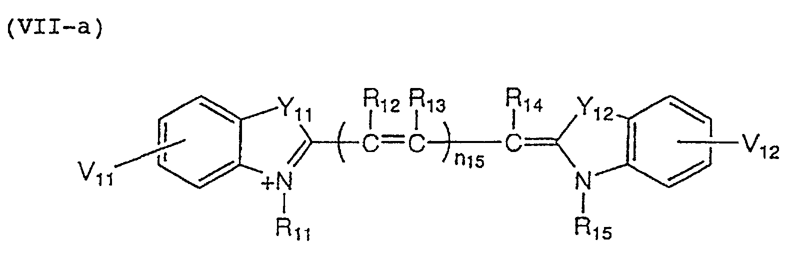 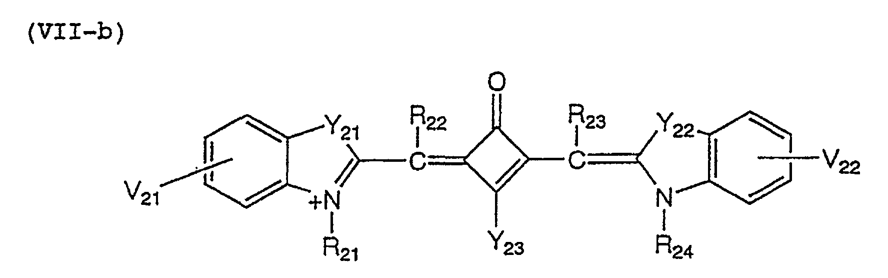 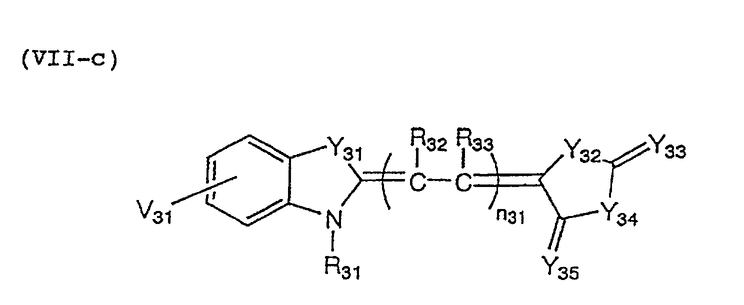 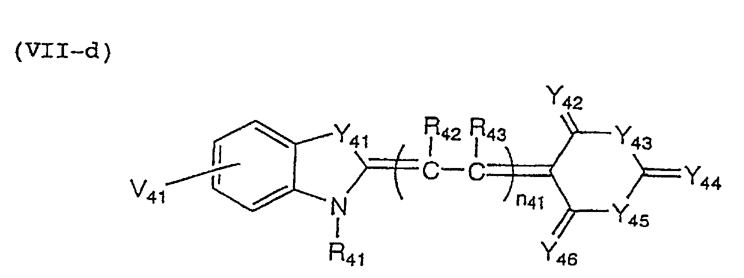 wherein R₁₁, R₁₂, R₁₃, R₁₄, R₁₅, R₂₁, R₂₂, R₂₃, R₂₄, R₃₁, R₃₂, R₃₃, R₄₁, R₄₂, and R₄₃ each represent a hydrogen atom, an alkyl group, an aryl group or a heterocyclic group; Y₁₁, Y₁₂, Y₂₁, Y₂₂, Y₃₁, Y₃₂, Y₃₃, Y₃₄, Y₃₅, Y₄₁, Y₄₂, Y₄₃, Y₄₄, Y₄₅, and Y₄₆ each represent an oxygen atom, a sulfur atom, a selenium atom, a tellurium atom, -CR₁₆R₁₇- or -NR₁₈-; R₁₆, R₁₇, and R₁₈ each represent a hydrogen atom, an alkyl group, an aryl group or a heterocyclic group; Y₂₃ represents O⁻, S⁻, Se⁻, Te⁻ or -NR₁₈⁻; V₁₁, V₁₂, V₂₁, V₂₂, V₃₁, and V₄₁ each represent a substituent; and n15, n31, and n41 each represent an integer of 1 to 6.

The compounds represented by formulae (VII-a) through (VII-d) may have a counter ion in agreement with the charge quantity of the whole molecule. In these formulae, the alkyl, aryl, and heterocyclic groups may have a substituent; the alkyl group may be straight or branched; and the aryl or heterocyclic group may be monocyclic or polycyclic (a condensed ring).

Examples of the above-described polymethine dyes are given in M. Okawara, T. Kitao, T. Hirashima, and M. Matuoka, *Organic Colorants*, Elsevier.

Specific examples of preferred polymethine dyes represented by formulae (V) and (VI) are shown below.

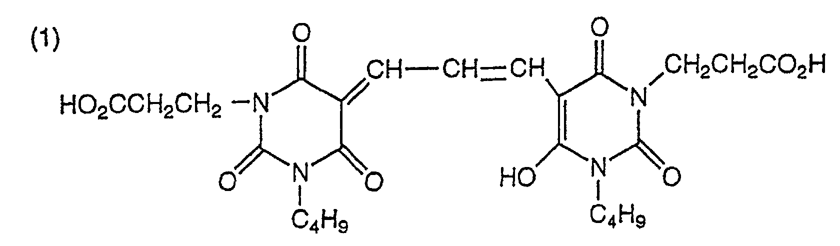

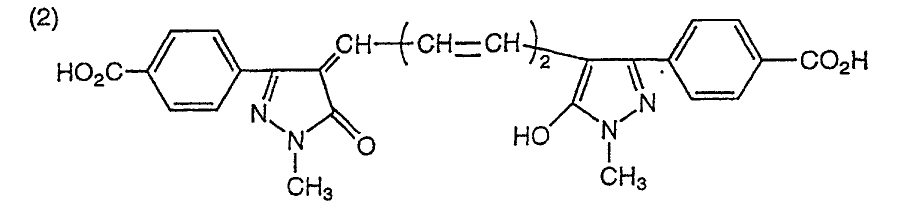

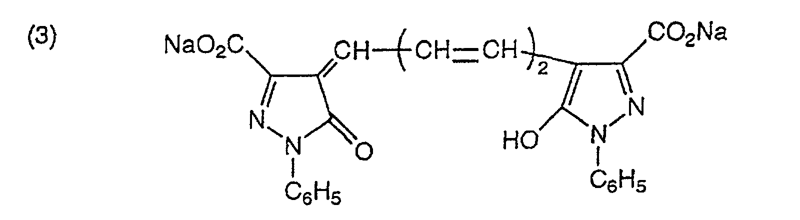

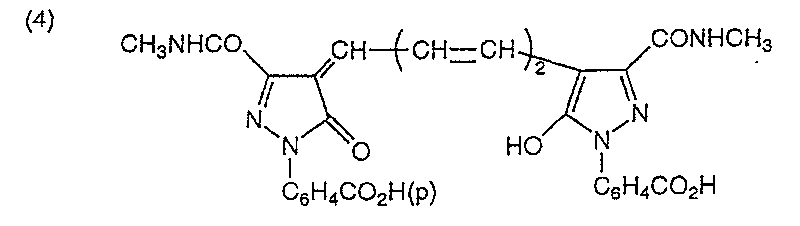

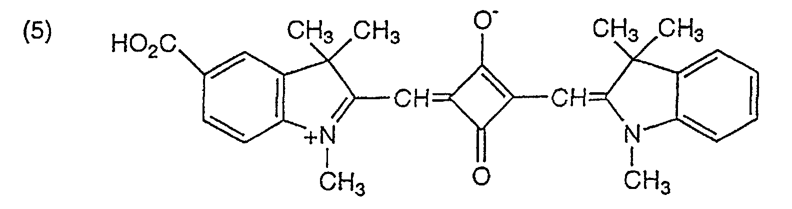

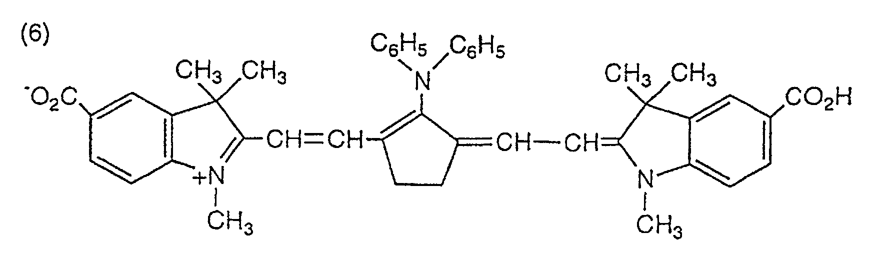

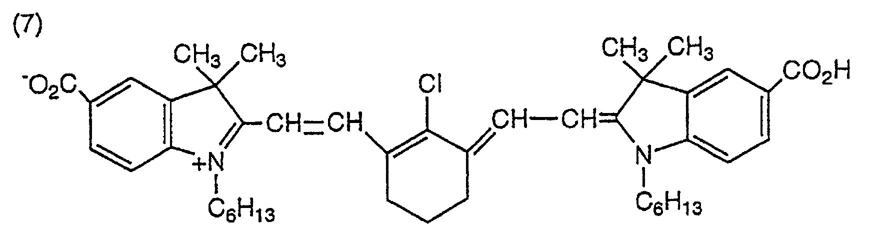

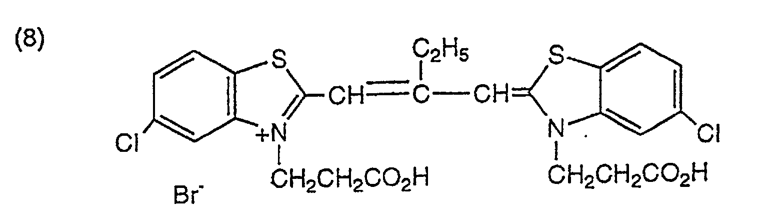

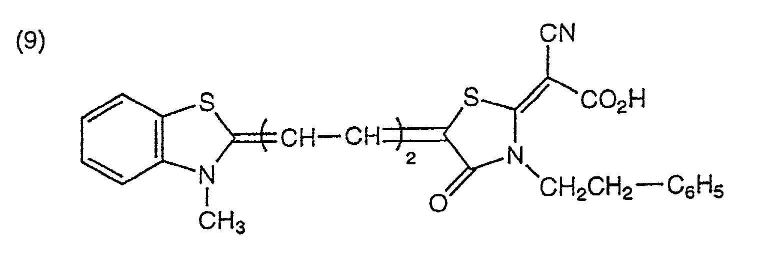

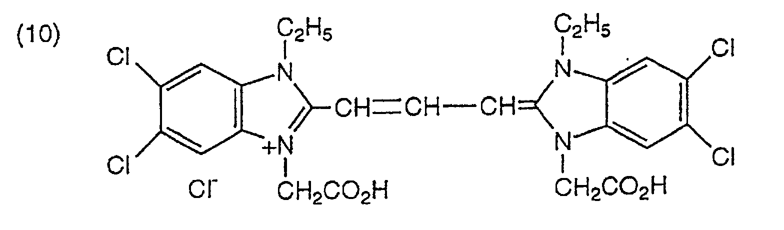

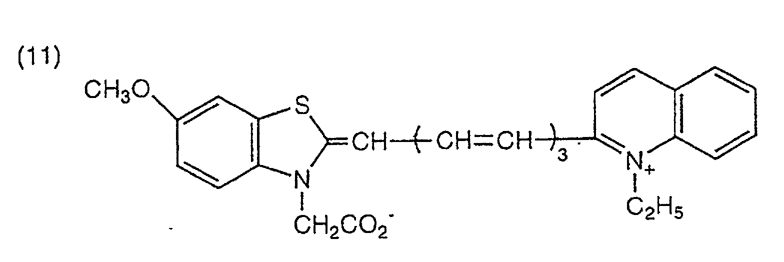

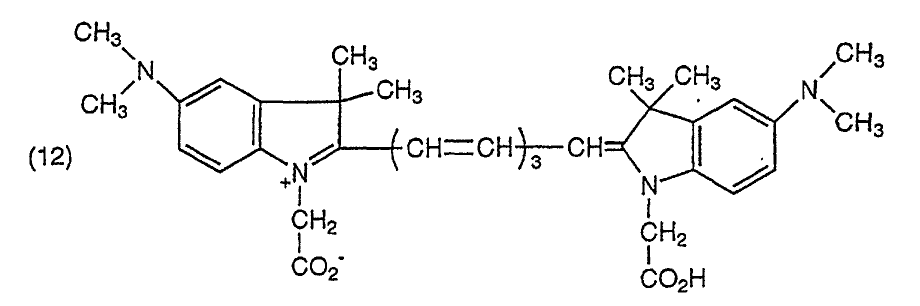

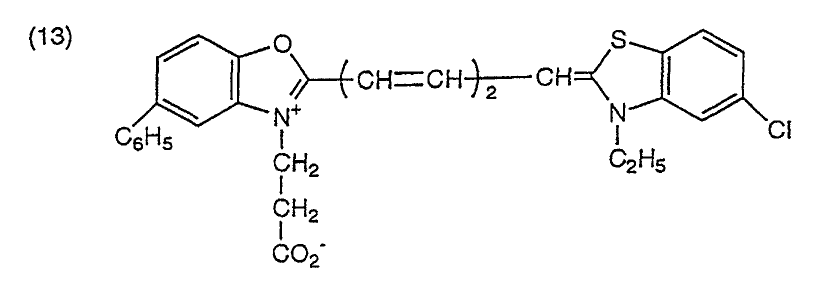

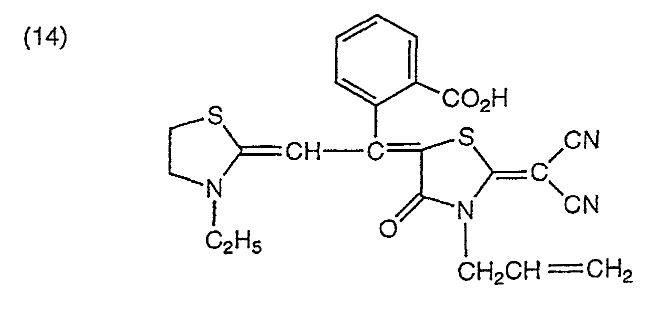

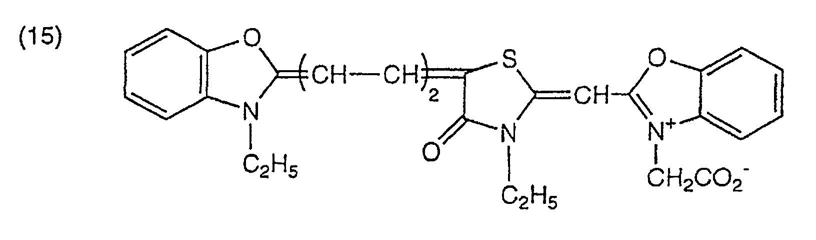

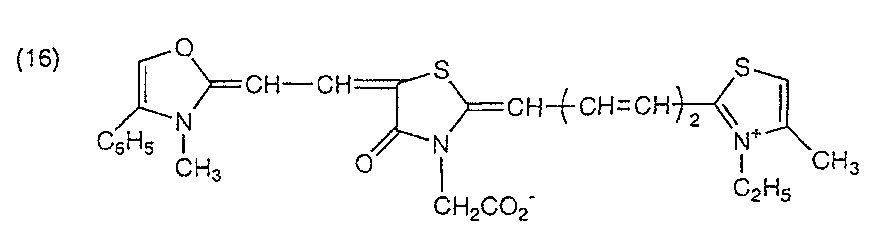

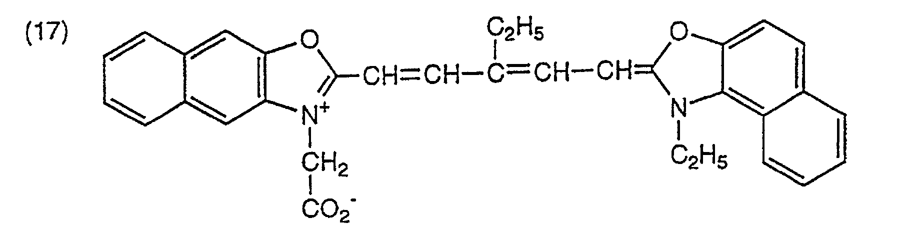

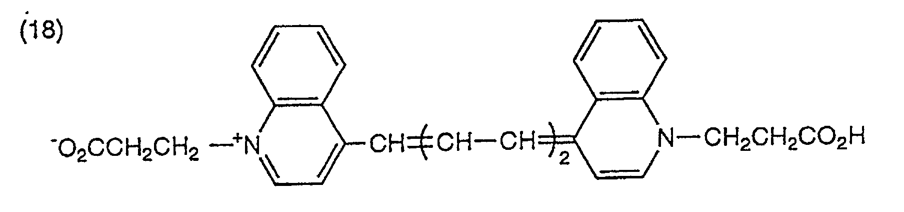

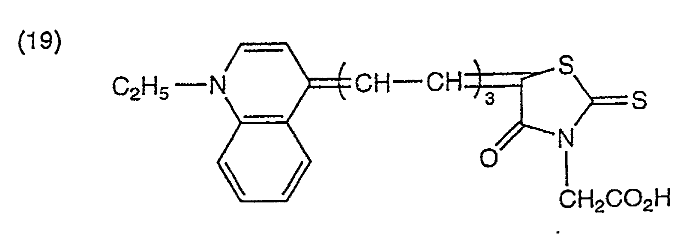

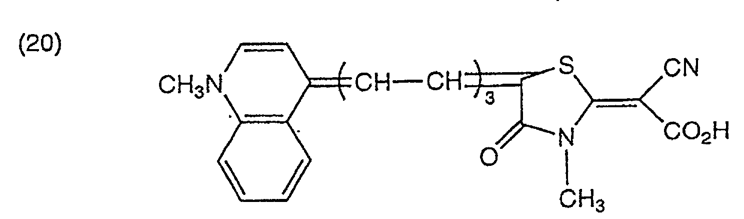

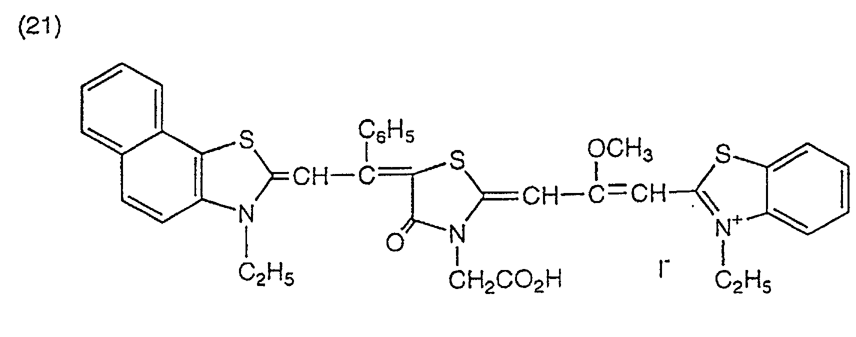

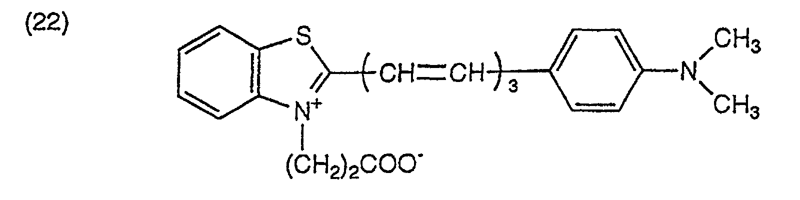

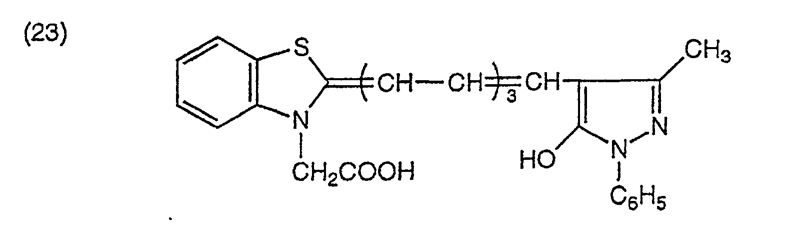

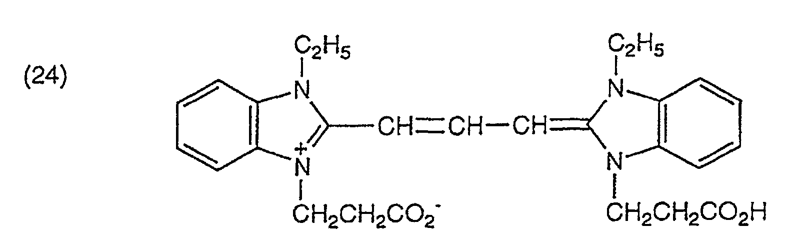

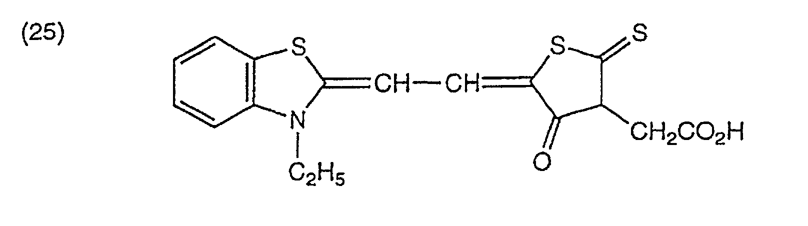

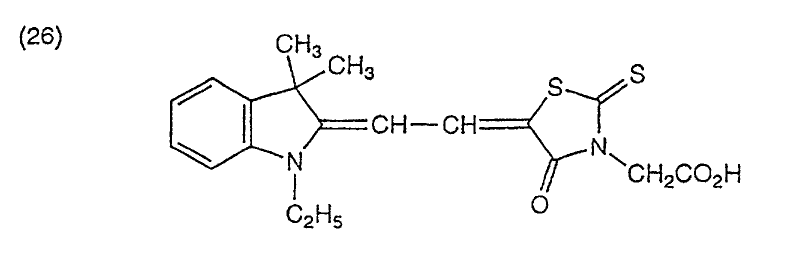

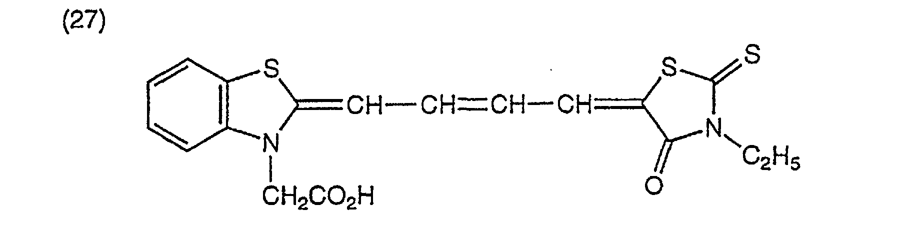

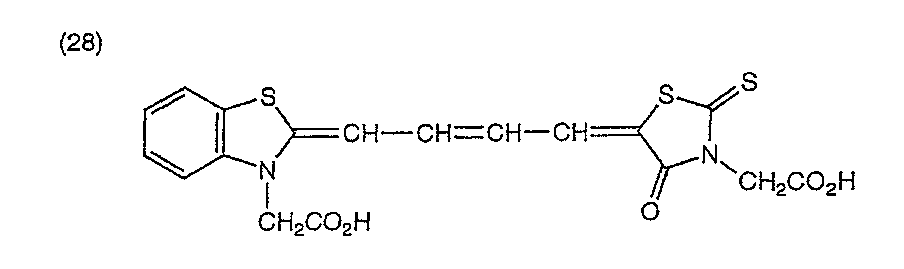

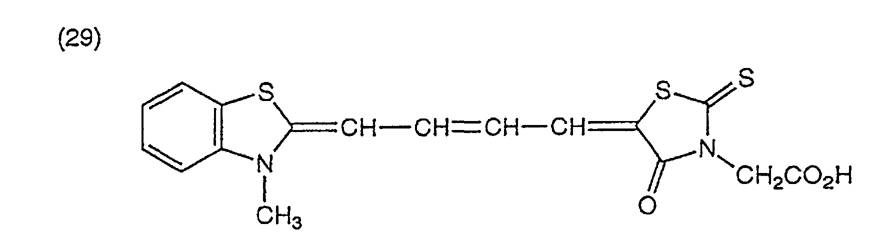

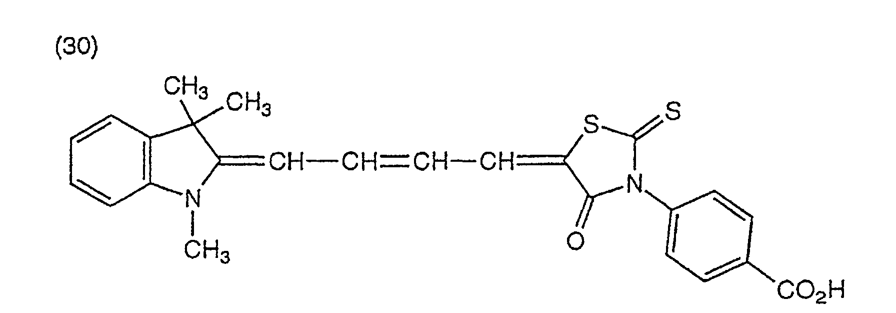

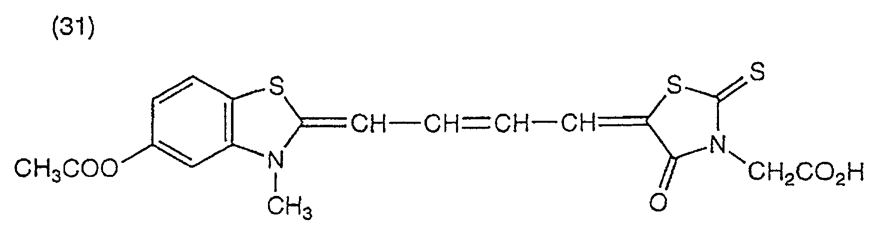

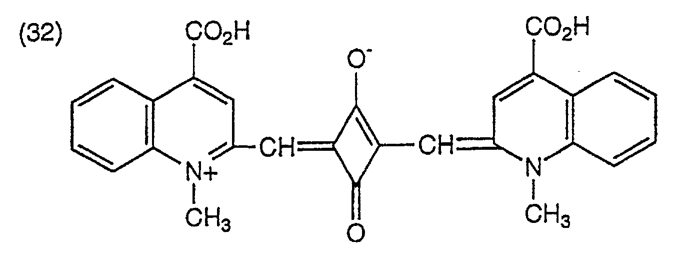

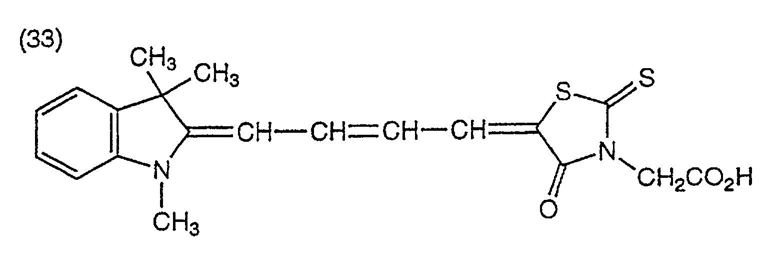

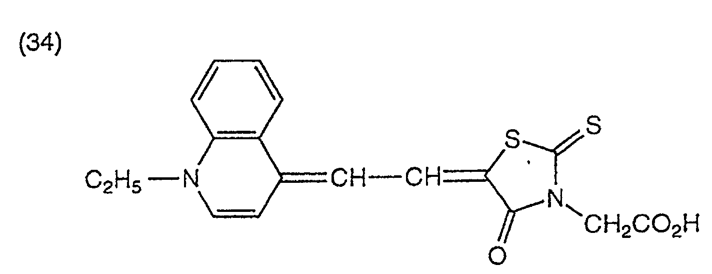

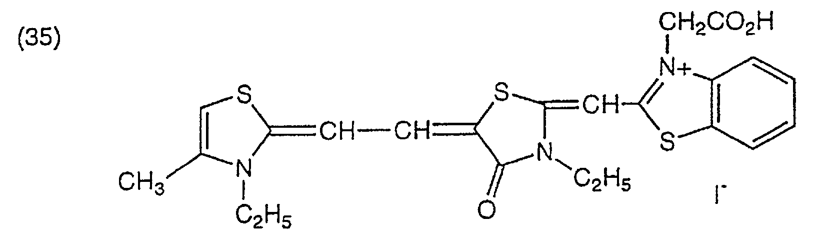

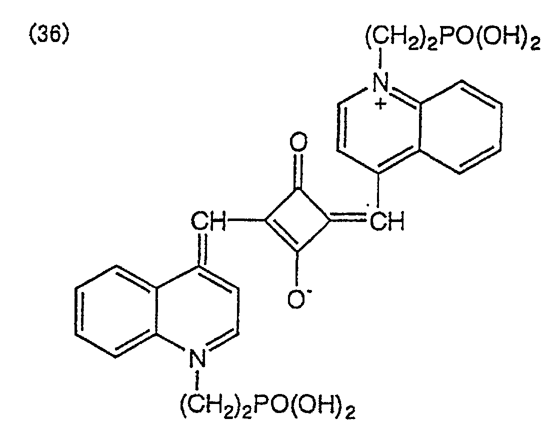

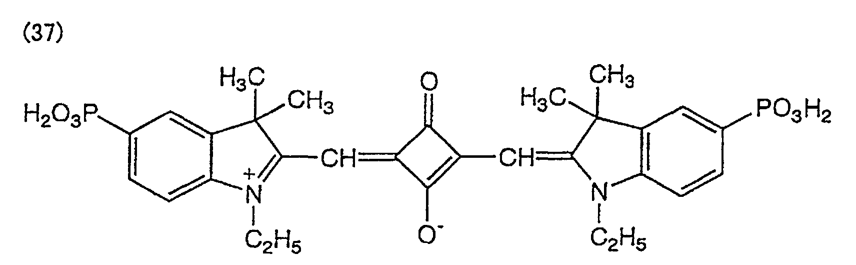

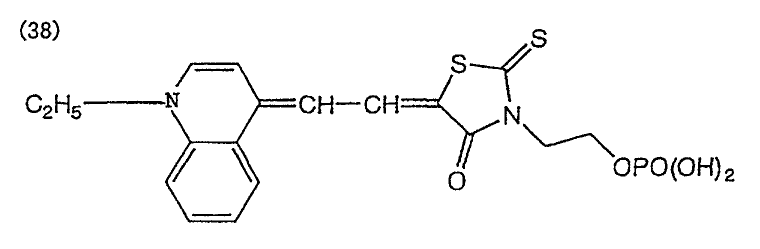

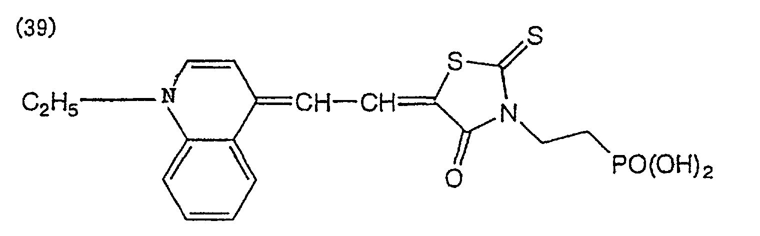

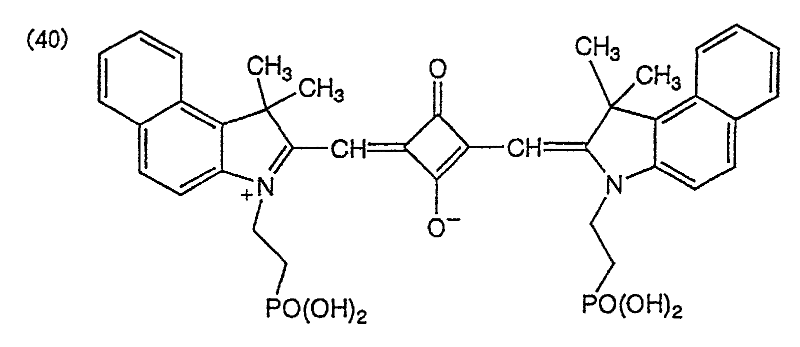

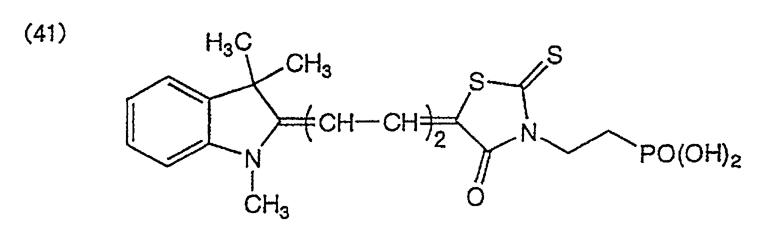

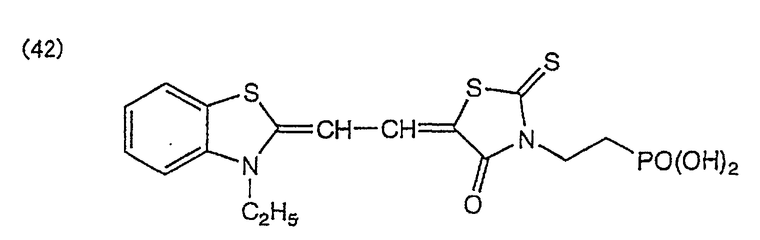

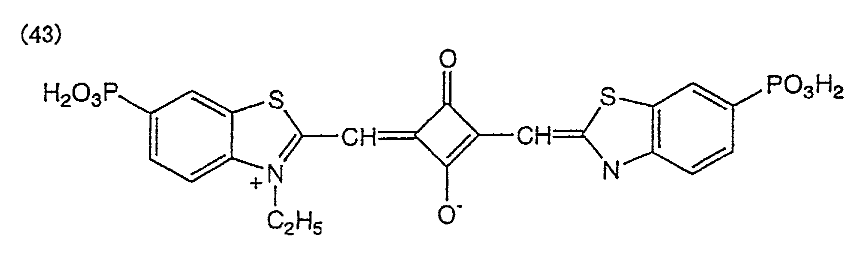

The compounds of formulae (V) and (VI) can be synthesized in accordance with the methods described, e.g., in F.M. Harmer, *Heterocyclic Compounds-Cyanine Dyes and Related Compounds*, John Wiley & Sons, New York & London (1964); D.M. Sturmer, *Heterocyclic Compounds-Special topics in heterocyclic chemistry,* Ch. 18, §14, Items 482-515, John Wiley & Sons, New York & London (1977); *Rodd's Chemistry of Carbon Compounds,* 2nd Ed., vol. IV, part B, Ch. 15, Items 369-422, Elsevier Science Publishing Co., Inc., New York (1977); and British Patent 1,077,611.

Adsorption of the dye onto semiconductor particles is usually effected by immersing well-dried semiconductor particles in a dye solution for several hours at room temperature or, as taught in JP-A-7-249790, while refluxing. Dye adsorption may be carried out either before or after applying the semiconductor particles to the substrate or simultaneously with application of the semiconductor particles. The unadsorbed dye is preferably removed by washing. Where the applied semiconductor particles are to be subjected to calcining, dye adsorption is preferably conducted after the calcining. It is particularly preferred that the dye be adsorbed quickly before water is adsorbed to the surface of the calcined semiconductor layer. The dyes may be used either individually or as a combination of two or more thereof. Where the dye-sensitized photoelectric conversion device is for a photo-electrochemical cell, the dyes to be combined can be selected so as to maximize the breadth of the wavelength region for photoelectric conversion.

In order to obtain a sufficient sensitizing effect, the dye or dyes are preferably present in an amount of 0.01 to 100 mmol per m² of the substrate and 0.01 to 1 mmol per gram of the semiconductor particles. With too small an amount of the dye, the sensitizing effect would be insufficient. If the dye is used in too large an amount, the non-adsorbed dye will float only to reduce the sensitizing effect.

A colorless compound may be adsorbed together with the dye so as to lessen the interaction among dye molecules, such as association. Hydrophobic compounds such as carboxyl-containing steroid compounds (e.g., cholic acid) can be used for this purpose.

After dye adsorption, the surface of the semiconductor particles can be treated with an amine, such as pyridine, 4-t-butylpyridine or polyvinylpyridine. The amine can be used as such where it is liquid, or as dissolved in an organic solvent.

The electrolyte that contains the polymer can be prepared by dissolving the polymer in the solvent of formula (I) or (II), and applying or infiltrating the resulting electrolytic solution to or into the semiconductor layer (electrode). The electrolyte containing the polymer can also be obtained by preparing a solution of monomers providing a desired polymer in the solvent of formula (I) or (II), applying or infiltrating the monomer solution to or into the semiconductor electrode, and causing the monomers to polymerize. Where a gel electrolyte is to be prepared, particularly where a crosslinked polymer is used, it is preferably formed by preparing a solution from the monomers, a polymerization initiator, other electrolyte components, and the solvent, applying the monomer solution to the electrode by casting, coating, dipping, impregnation or a like method to form a sol electrolyte layer, and causing the monomers to polymerize to make the sol into gel. Additives such as coating improvers (e.g., a leveling agent) can be added to the coating monomer solution. Methods for coating with the monomer solution include spin coating, dip coating, air knife coating, curtain coating, roller coating, wire bar coating, gravure coating, extrusion coating by use of a hopper (see U.S. Patent 2,681,294), and multilayer simultaneous coating (see U.S. Patents 2,761,418, 3,508,947, and 2,761,791). After coating, radical polymerization is carried out at a temperature appropriately decided according to the half decay temperature of the initiator, the heat resistance temperature of the dye, and the like, preferably 10 to 150°C, for a period properly selected according to the reaction conditions such as temperature. Where a substance in a reduced state such as iodine is introduced into the electrolyte, cases are sometimes met with in which the substance acts as a polymerization inhibitor to hinder the polymerization of the monomers. To avoid this, introduction of a substance in a reduced state, such as iodine, can be performed by, for example, putting a semiconductor electrode having a gel electrolyte and the substance (e.g., iodine) in a closed container thereby to let the substance diffuse into the gel electrolyte. It is possible to introduce a substance in a reduced state (e.g., iodine) into a device by applying the substance to the counter electrode by coating or vacuum deposition.

In a photo-electrochemical cell using the photoelectric conversion device, the counter electrode functions as a positive electrode. The counter electrode usually has a conductive substrate, such as those described above for use in the semiconductor electrode, but a substrate is not always required as far as sufficient strength is secured. For achieving air tightness, use of a substrate is advantageous, though.

At least one of the conductive substrate of the semiconductor electrode and the counter electrode must be substantially transparent so that incident light can reach the photosensitive layer. It is preferred for the photo-electrochemical cell of the invention that the conductive substrate of the semiconductor electrode be transparent and that light be incident upon this side. In this case, it is still preferred that the counter electrode have light reflecting properties.

The counter electrode that can be used in photo-electrochemical cells includes glass or plastic having metal or a conductive oxide deposited thereon. Metal can be deposited by vacuum evaporation, sputtering or a like technique for thin film formation to obtain a deposit thickness of 5 µm or less, preferably 5 nm to 3 µm. A preferred counter electrode is a glass plate having platinum deposited thereon by vacuum evaporation or a metal thin film formed by vacuum evaporation or sputtering.

The photosensitive layer may have a single layer structure or a multilayer structure as designed according to the end use. A single photosensitive layer may have a dye of a kind or a mixture of two or more kinds of dyes.

The photo-electrochemical cell of the invention may have its sides sealed with a polymer, an adhesive, etc. to prevent deterioration by oxidation.

Preferred embodiments of the electrolyte used in the device or the cell of the present invention are shown below, as well as embodiments of the device or the cell.
(1) An electrolyte containing as a solvent at least one compound selected from a compound represented by formula (I) and a compound represented by formula (II), as described above.
(2) The electrolyte according to (1) further containing at least one polymer whose main chain is selected from polyethylene oxide, polypropylene oxide, polyacrylic acid esters, polymethacrylic acid esters, polyvinyl alcohol, polyacrylamide, polyallylamine, polysilane, polyacrylonitrile, polystyrene, polyvinylpyridine, polyvinylimidazole, polyfluoroethylene, and polyvinylidene fluoride, and copolymers comprising two or more of the monomers constituting these homopolymers.
(3) The electrolyte according to (2), wherein the polymer has at least one substituent selected from an oxyethylene group, an oxypropylene group, a heterocyclic group, a cyano group, and a carbonate group in the side chain thereof.
(4) The electrolyte according to (2), wherein the main chain of the polymer is polyacrylonitrile or polyvinylidene fluoride.
(5) The electrolyte according to (2), wherein the polymer is a crosslinked polymer.
(6) The electrolyte according to (5), wherein the crosslinked polymer is represented by formula (III): 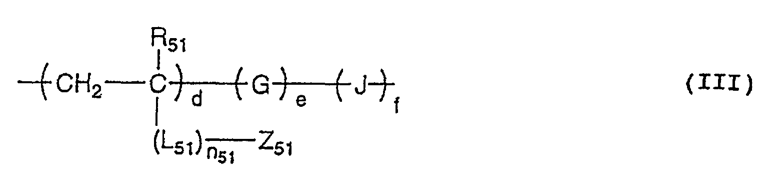 wherein R₅₁ represents a hydrogen atom, an alkyl group or an aryl group; Z₅₁ represents a monovalent organic group having at least one group selected from the group consisting of a heterocyclic group, a cyano group, a carbonate group, -(CH₂CH₂O)ₙ₅₂-R₅₂, and -[CH₂CH(CH₃)O]ₙ₅₃-R₅₃; L₅₁ represents -COO-, -OCO-, -CONR₅₄- or -NR₅₄CO-; n51 represents 0 or 1; R₅₂, R₅₃, and R₅₄ each represent a hydrogen atom, an alkyl group, a cycloalkyl group, an alkenyl group or an aryl group; n52 and n53 each represent an integer of 1 to 30; G represents a repeating unit derived from a compound containing an ethylenically unsaturated group; J represents a repeating unit derived from a compound containing two or more ethylenically unsaturated groups; and d, e, and f represent the weight ratios of the respective repeating units, wherein d is 5 to 99% by weight, e is 0 to 70% by weight, and f is 0.5 to 50% by weight.
(7) The electrolyte according to (6), wherein L₅₁ is -COO- (bonded to Z₅₁ at the oxygen atom) or -CONR₅₄- (bonded to Z₅₁ at the nitrogen atom).
(8) The electrolyte according to (6), wherein n52 and n53 each represent an integer of 1 to 10.
(9) The electrolyte according to (6), wherein d is 20% by weight or more.
(10) The electrolyte according to (1), wherein R₃ is a cyano group.
(11) The electrolyte according to (1), wherein the compound as the solvent is at least one compound selected from a compound represented by formula(I).
(12) The electrolyte according to (1), wherein the electrolyte is a gel electrolyte.
(13) The electrolyte according to (12), wherein the electrolyte further contains a gelling agent having a molecular weight of 1,000 or less.
(14) The electrolyte according to (13), wherein the gelling agent has at least one amido group in the molecular structure.
(15) The electrolyte according to any of (1) to (14) used in a photo-electrochemical cell.
(16) A photoelectric conversion device comprising a semiconductor, an electrically conductive substrate, a counter electrode and an electrolyte containing as a solvent at least one compound selected from a compound represented by formula (I) and a compound represented by formula (II), as described above.
(17) The photoelectric conversion device according to (16), wherein the semiconductor is a dye-sensitized particulate semiconductor.
(18) The photoelectric conversion device according to (16), wherein the semiconductor is contained in a semiconductor-containing layer provided on the electrically conductive substrate, and the electrolyte is contained in an electrolyte-containing layer.
(19) The photoelectric conversion device according to (16), wherein the electrolyte is a gel electrolyte containing further a gelling agent having a molecular weight of 1,000 or less.
(20) The photoelectric conversion device according to (19), wherein the gelling agent has at least one amido group in the molecular structure.
(21) A photo-electrochemical cell comprising a photoelectric conversion device which comprises a semiconductor, an electrically conductive substrate, a counter electrode and an electrolyte containing as a solvent at least one compound selected from a compound represented by formula (I) and a compound represented by formula (II), as described above.
(22) The photo-electrochemical cell according to (21), wherein the photo-electrochemical cell comprises the photoelectric conversion device comprising the electrically conductive substrate, the semiconductor which is responsive to radiations contained in a semiconductor-containing layer provided on the electrically conductive substrate, the electrolyte contained in an electrolyte-containing layer which is a charge transporting layer and the counter electrode.
(23) The photo-electrochemical cell according to (21), wherein the electrolyte is a gel electrolyte.
(24) The photo-electrochemical cell according to (23), wherein the gel electrolyte further contains a gelling agent having a molecular weight of 1,000 or less.
(25) The photo-electrochemical cell according (23), wherein the gelling agent has at least one amide group in the molecular structure.
(26) The photo-electrochemical cell according to (21), wherein the semiconductor is a dye-sensitized particulate semiconductor.
(27) The photo-electrochemical cell according to (26), wherein the particulate semiconductor is a metal chalcogenide.
(28) The photo-electrochemical cell according to (27), wherein the metal chalcogenide contains titanium oxide.
(29) The photo-electrochemical cell according to (26), wherein the dye is a metal complex dye and/or a polymethine dye.

### EXAMPLE

The present invention will now be illustrated in greater detail with reference to Examples, but it should be understood that the invention is not limited thereto.

### EXAMPLE 1

Compound S-2 represented by formula (II) and compound S-11 represented by formula (I) were synthesized according to the following reaction schemes:

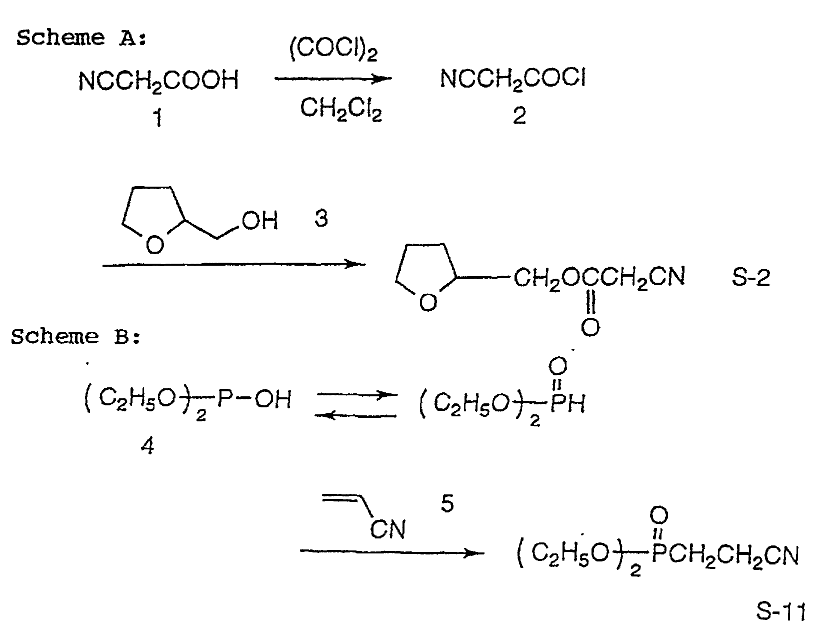

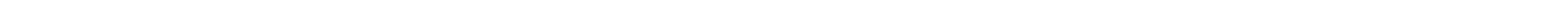

### (1) Synthesis of Compound S-2 (Scheme A)

In 75 ml of methylene chloride were dissolved 25.5 g (0.3 mol) of cyanoacetic acid (1) and 0.1 ml of dimethylformamide (DMF), and 57.2 g (0.45 ml) of oxalyl chloride was slowly added thereto dropwise, followed by stirring for 30 minutes. The solvent, etc. were evaporated under reduced pressure to obtain 31.1 g (yield: 100%) of an acid chloride (2). In 50 ml of acetonitrile was dissolved 15.3 g (0.15 mol) of 2-furylmethyl alcohol (3), and 15.5 g (0.15 mol) of the acid chloride was added thereto dropwise, and the mixture was stirred at 50°C for 1 hour. After concentration, the reaction product was purified by column chromatography on silica gel using a 1:2 to 1:1 mixed solvent of ethyl acetate and hexane as an eluent to give 17.0 g (yield: 66.9%) of liquid compound S-2.
- ¹H-NMR: (CDCl₃, δ, ppm): 1.6-2.2 (4H, m, tetrahydrofuran (THF)), 3.52 (2H, s, -CH₂CN), 3.75-3.95 (2H, m, -OCH₂- (THF)), 4.17 (2H, t, -COOCH₂-), 4.2-4.3 (1H, m, =CH-O- (THF)).

### (2) Synthesis of Compound S-11 (Scheme B)

In 50 ml of dimethylacetamide were dissolved 41.4 g. (0.3 mol) of phosphorous acid (4) and 45.6 g (0.3 mol) of 1,8-diazabicyclo[5.4.0]-7-undecene (DBU), and 19.1 g (0.36 mol) of acrylonitrile (5) was slowly added thereto dropwise, followed by stirring at 40°C for 1 hour. Acrylonitrile, dimethylacetamide, and DBU were removed by evaporation at 80°C under reduced pressure, and the residue was purified by silica gel column chromatography using ethyl acetate as an eluent to give 54.0 g (94%) of liquid compound S-11.
- ¹H-NMR: (CDCl₃, δ, ppm): 1.35 (6H, t, -CH₃), 2.0-2.2 (2H, m, -P(O)CH₂-), 2.55-2.7 (2H, m, -CH₂CN), 4.05-4.25 (4H, m, -CH₂O-).

### EXAMPLE 2

The boiling points of compounds S-2 and S-11 synthesized in Example 1 and compound S-14 were measured in a sand bath under atmospheric pressure. The results obtained are shown in Table 2. For reference, the boiling points of propylene carbonate (PC), ethylene carbonate (EC), dimethoxyethane (DME) and acetonitrile (AN) are also shown in Table 2.

**TABLE 2**

| Organic Solvent | Boiling Point (°C; 1 atm) | Remark |
|---|---|---|
| S-2 | 290 | invention |
| S-11 | 280 | " |
| S-14 | 290 | " |
| PC | 240 | comparison |
| EC | 244 | " |
| DME | 85 | " |
| AN | 82 | " |

As is apparent from Table 2, compounds S-2, S-11, and S-14 according to the present invention have a boiling point of not less than 270°C, which is much higher than the boiling points of PC, EC, DME, and AN. The results in Table 2 verify that the compounds used in the invention are high-boiling solvents, i.e., low-volatile solvents.

### EXAMPLE 3

### 1) Preparation of titanium dioxide dispersion

In a 200 ml-volume stainless steel-made vessel having its inner wall coated with Teflon were charged 15 g of titanium dioxide (Degussa P-25, produced by Nippon Aerosil Co., Ltd.), 45 g of water, 1 g of a dispersant (Triton X-100, produced by Aldrich), and 30 g of zirconia beads having a diameter of 0.5 mm (produced by Nikkato Corp.) and dispersed by means of a sand grinder mill (produced by Imex Co., Ltd) at 1500 rpm for 2 hours. The zirconia beads were filtered off from the dispersion. The average particle size of the dispersed titanium dioxide particles was 2.5 µm as measured with Mastersizer manufactured by Malvern.

### 2) Preparation of dye-sensitized TiO₂ electrode

Electrically conductive glass having an F-doped tin oxide coat (TCO Glass-U, produced by Asahi Glass Co., Ltd.; surface resistivity: about 30 Ω/cm²) was cut to squares with 20 mm-sides. The titanium dioxide dispersion prepared in (1) was applied with a glass bar to the conductive side of 8 glass pieces at a time in the following manner. An adhesive tape was stuck to one end (over a 3 mm width from the edge) of the conductive surface of each glass piece, and 8 glass pieces were arrayed in two lines without gap to make a 4 cm wide and 8 cm long strip with their adhesive tape-stuck edges making both sides (8 cm long) of the strip as spacers. The coating weight of the titanium dioxide particles was adjusted to 20 g/m². After coating, the adhesive tape was removed. The coating layer was air-dried at room temperature for 1 day and then calcined in an electric muffle furnace (Model FP-32, manufactured by Yamato Kagaku) at 450°C for 30 minutes. After being cooled out of the furnace, the coated glass substrates were immersed in a 3 × 10⁻⁴ mol/l ethanol solution of the dye shown in Table 3 below for 3 hours. The amount of the dye coated was selected appropriately from 0.1 to 10 mmol/m² according to the dye. The dyed glass substrates were then immersed in 4-t-butylpyridine for 15 minutes, washed with ethanol, and dried spontaneously to obtain a dye-sensitized TiO₂ electrode substrate. The thickness of the dye-sensitized TiO₂ layer (photosensitive layer) thus formed was 10 µm.

### 3) Preparation of photo-electrochemical cell

An electrolytic solution was prepared by dissolving the supporting electrolyte shown in Table 3 and iodine in the organic solvent shown in Table 3 in concentrations of 0.65 mol/l and 0.05 mol/l, respectively.

As shown in Fig. 1, the electrode substrate prepared in the above item 2), and a Pt-deposited glass substrate of the same size (2 cm × 2 cm) were brought into contact with the electrode layer 3 and the Pt deposit layer 6 facing each other. The electrolytic solution was introduced into the gap between the glass substrates by making use of capillarity so as to penetrate into the TiO₂ electrode. There were thus obtained photo-electrochemical cells 301 to 330 composed of a conductive glass substrate (glass 1 having a conductor layer 2), a TiO₂ electrode 3, a dye layer 4, an electrolytic solution 5, a Pt layer 6, and glass 7.

**TABLE 3**

| Cell No. | Dye | Solvent (volume ratio) | Supporting Electrolyte | Remark |
|---|---|---|---|---|
| 301 | R-1 | NMO | MBIm | comparison |
| 302 | R-1 | EC/NMO=1/1 | MBIm | " |
| 303 | R-1 | DME/NMO=1/1 | MBIm | " |
| 304 | R-1 | AN/NMO=8/2 | MBIm | " |
| 305 | R-1 | S-2 | MBIm | invention |
| 306 | R-1 | S-11 | MBIm | " |
| 307 | R-1 | S-11 | LiI | " |
| 308 | R-1 | S-11 | (C₃H₇)₄NI | " |
| 309 | R-1 | S-11 | MHIm | " |
| 310 | R-13 | S-2 | MBIm | " |
| 311 | R-13 | S-11 | MBIm | " |
| 312 | R-14 | S-11 | MBIm | " |
| 313 | R-16 | S-2 | MBIm | " |
| 314 | R-17 | S-11 | MBIm | " |
| 315 | (1) | S-2 | (C₃H₇)₄NI | " |
| 316 | (3) | S-14 | LiI | " |
| 317 | (5) | S-2 | MHIm | " |
| 318 | (5) | S-11 | MBIm | " |
| 319 | (26) | S-2 | MBIm | " |
| 320 | (26) | S-11 | MBIm | " |
| 321 | (29) | S-2 | MBIm | " |
| 322 | (29) | S-11 | MBIm | " |
| 323 | (32) | S-14 | MBIm | " |
| 324 | (37) | EC/NMO=1/1 | MBIm | comparison |
| 325 | (37) | AN/NMO=8/2 | MBIm | " |
| 326 | (37) | S-2 | MBIm | invention |
| 327 | (37) | S-11 | MBIm | " |
| 328 | (40) | S-2 | MBIm | " |
| 329 | (40) | S-11 | MBIm | " |
| 330 | (43) | S-11 | MBIm | " |

Abbreviations in Table 3 have the following meanings (hereinafter the same).
- NMO:: 3-methyl-2-oxazolidinone
- EC:: ethylene carbonate
- DME:: dimethoxyethane
- AN:: acetonitrile
- MHIm:: 1-methyl-3-hexylimidazolium iodide
- MBIm:: 1-methyl-3-butylimidazolium iodide

### 4) Measurement of photoelectric conversion efficiency

The conductive glass 1 and the Pt-deposited glass 7 were connected by means of alligator clips, and the cell was irradiated with pseudo-sunlight containing no ultraviolet rays having an intensity of 86 mW/cm² which was obtained by cutting light from a 500 W xenon lamp (produced by Ushio Inc.) through AM1.5 Filter (produced by Oriel) and a sharp cut filter (Kenko L-42). The generated electricity was measured with a current-voltage meter (Keithley Model SMU238) to obtain an open circuit voltage (V_{OC}), a short circuit current density (J_{SC}), a fill factor (FF), and a conversion efficiency (η). After 24-hour continuous irradiation, the short circuit current density was again measured to obtain a rate of reduction. The results obtained are shown in Table 4 below.

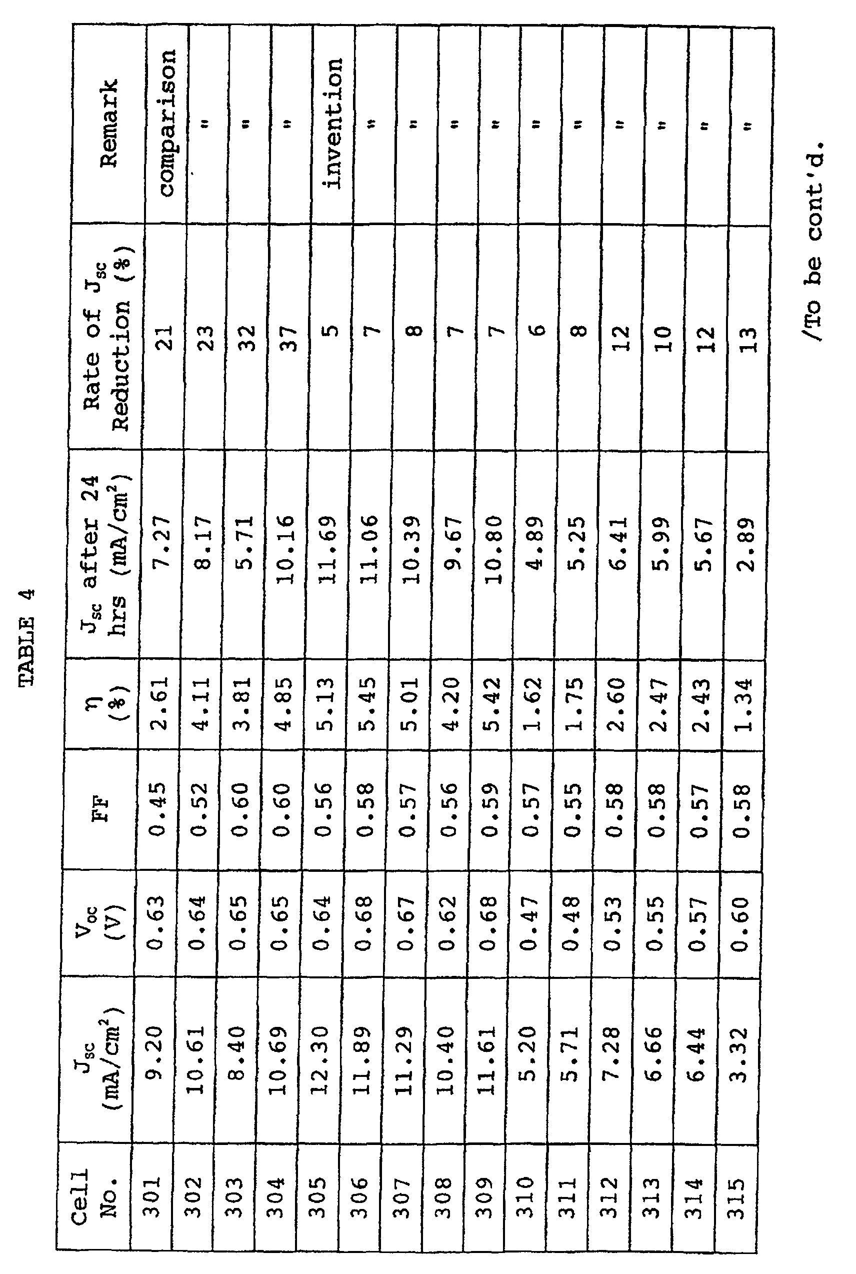

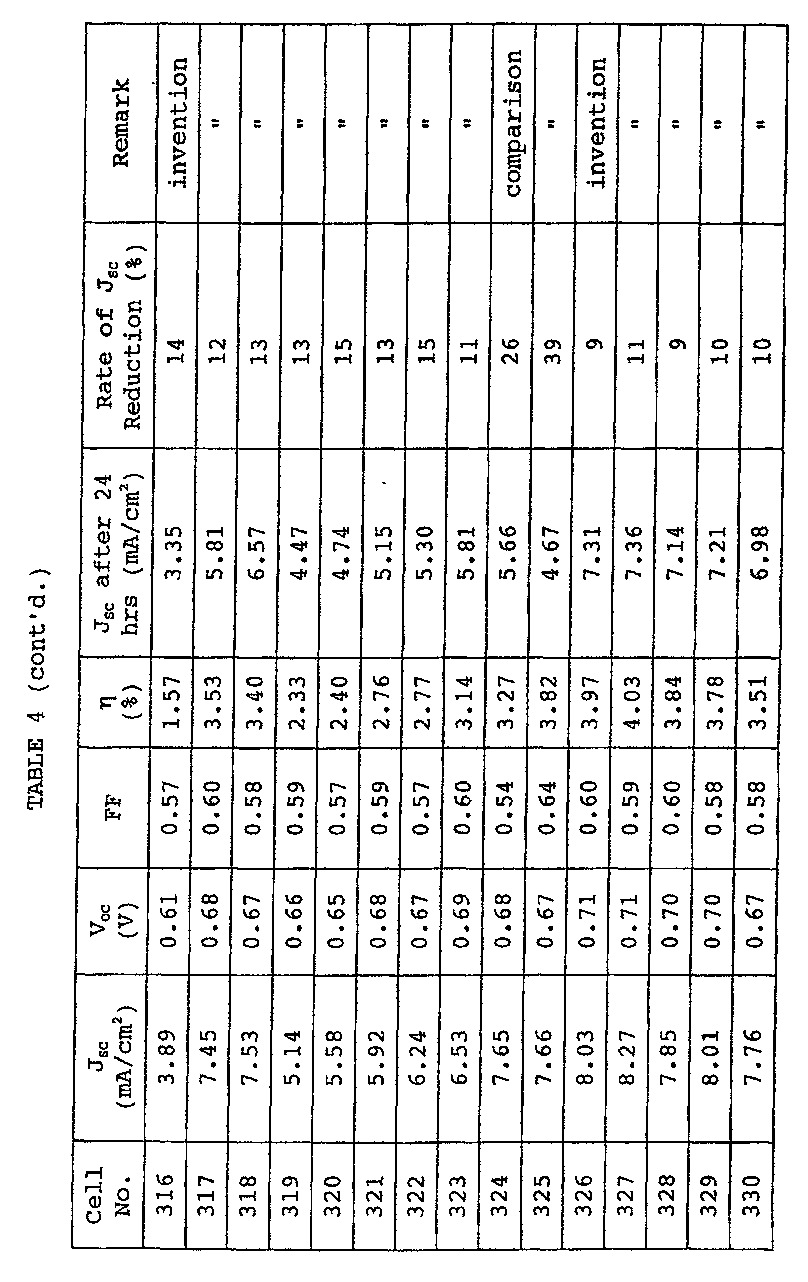

The results in Table 4 prove that the cells of the invention, in which the high-boiling compound (I) or (II) is used as a solvent of the electrolytic solution, are less susceptible to deterioration in photoelectric conversion characteristics irrespective of the kinds of the sensitizing dye and the supporting electrolyte as compared with the comparative cells using conventional organic solvents having a relatively low-boiling point. It is also ascertained that the cells of the invention are excellent in initial performance, such as a short circuit current density and conversion efficiency.

### EXAMPLE 4

### 1) Preparation of titanium dioxide dispersion

A titanium dioxide dispersion was prepared in the same manner as in Example 3.

### 2) Preparation of dye-sensitized TiO₂ electrode

A TiO₂ electrode substrate was prepared in the same manner as in Example 3.

### 3) Preparation of photo-electrochemical cell containing a gel electrolyte

As shown in Fig. 1, the TiO₂ electrode prepared in the above item 2) and a Pt-deposited glass substrate of the same size were brought into contact with the electrode layer 3 and the Pt deposit layer 6 facing each other.

An electrolytic solution was prepared by dissolving the supporting electrolyte shown in Table 5 below in the organic solvent shown in Table 5 in a concentration of 0.5 mol/l. Monomers providing the polymer shown in Table 5 were added to the solution in an amount of 10% by weight based on the total organic solvent, and 2,2'-azobisisobutyronitrile was added thereto in an amount of 0.5% by weight based on the total organic solvent. After bubbling argon gas through the solution for 5 minutes, the solution was infiltrated into the TiO₂ electrode by making use of osmotic pressure. The electrode was heated at 85°C in an argon atmosphere to gelatinize (polymerize) the solution. The electrode having the gel electrolyte was exposed to iodine for 30 minutes to make iodine diffuse in the polymer. There were thus obtained photo-electrochemical cells 401 to 428 composed of a conductive glass substrate (glass 1 having a conductor layer 2), a TiO₂ electrode 3, a dye layer 4, an electrolytic layer 5, a Pt layer 6, and glass 7, as shown in Fig. 1.

**TABLE 5**

| Cell No. | Dye | Solvent (volume ratio) | Supporting Electrolyte | Polymer | Remark |
|---|---|---|---|---|---|
| 401 | R-1 | AN/NMO=8/2 | MHIm | P-14 | comparison |
| 402 | R-1 | PC | MHIm | P-14 | " |
| 403 | R-1 | NMO/EC=1/1 | MHIm | P-14 | " |
| 404 | R-1 | NMO/DME=1/1 | MHIm | P-14 | " |
| 405 | R-1 | S-2 | MHIm | P-14 | invention |
| 406 | R-1 | S-11 | MHIm | P-14 | " |
| 407 | R-1 | S-11 | MHIm | P-1 | " |
| 408 | R-1 | S-11 | MHIm | P-2 | " |
| 409 | R-1 | S-11 | (C₃H₇)₄NI | P-15 | " |
| 410 | R-1 | S-11 | MHIm | P-18 | " |
| 411 | R-1 | S-11 | LiI | P-22 | " |
| 412 | R-1 | S-11 | MHIm | P-25 | " |
| 413 | R-1 | S-11 | MHIm | P-31 | " |
| 414 | R-1 | S-11 | MHIm | P-33 | " |
| 415 | R-1 | S-11 | MHIm | P-34 | " |
| 416 | R-13 | S-11 | MHIm | P-14 | " |
| 417 | (1) | S-2 | LiI | P-31 | " |
| 418 | (3) | S-11 | (C₃H₇)₄NI | P-34 | " |
| 419 | (5) | S-11 | MHIm | P-14 | " |
| 420 | (5) | S-11 | MHIm | P-1 | " |
| 421 | (5) | S-11 | MHIm | P-33 | " |
| 422 | (26) | S-11 | MHIm | P-2 | " |
| 423 | (29) | S-11 | MHIm | P-15 | " |
| 424 | (32) | S-11 | MHIm | P-18 | " |
| 425 | (37) | S-11 | MHIm | P-22 | " |
| 426 | (37) | S-11 | MHIm | P-31 | " |
| 427 | (37) | S-11 | MHIm | P-34 | " |
| 428 | (40) | S-2 | MHIm | P-25 | " |

### 3) Preparation of comparative photo-electrochemical cells A, B, and C

A photo-electrochemical cell A was prepared in the same manner as described above, except that an electrolytic solution prepared by dissolving 0.05 mol/l of iodine and 0.5 mol/l of lithium iodide in a 90/10 (by volume) mixed solvent of acetonitrile and 3-methyl-2-oxazolidinone was introduced into the gap between the glass substrates by making use of capillarity.

A photo-electrochemical cell B was prepared in accordance with JP-A-9-27352 as follows. Lithium iodide (500 mg) was dissolved in a mixture consisting of 1 g of hexaethylene glycol methacrylate (Blenmer PE350, produced by Nippon Yushikagaku K.K.), 1 g of ethylene glycol, and 20 mg of 2-hydroxy-2-methyl-1-phenyl-propan-1-one (Darocure 1173, produced by Chiba-Geigy (Japan) Ltd.) as a polymerization initiator. After deaeration in vacuo for 10 minutes, the solution was applied to the dye-sensitized TiO₂ electrode substrate (2 cm × 2 cm) prepared in the same manner as described above. The resulting coated electrode was placed under reduced pressure to remove air bubbles in the impregnated electrode and to promote penetration of the monomers. The coated electrode was irradiated with ultraviolet light to cause the monomers to polymerize to form uniform polymer gel in the voids of the porous TiO₂ electrode. The electrode was exposed to iodine for 30 minutes to make iodine diffuse into the polymer to obtain a photo-electrochemical cell B.

A photo-electrochemical cell C was prepared in the same manner as for the cell B in accordance with JP-A-9-27352, except that the dye-sensitized TiO₂ electrode substrate was coated with a monomer solution prepared by dissolving 500 mg of lithium iodide in a mixture consisting of 1 g of hexaethylene glycol methacrylate (Blenmer PE350), 100 mg of ethylene glycol diacrylate, 3 g of propylene carbonate (solvent capable of dissolving the electrolyte), and 20 mg of 2-hydroxy-2-methyl-1-phenyl-propan-1-one (Darocure 1173).

### 4) Measurement of photoelectric conversion efficiency

The performance of the resulting photo-electrochemical cells was evaluated in the same manner as in Example 3, except that deterioration of photoelectric conversion efficiency was judged from the initial short circuit current density (J_{SC}) and that after 360-hour continuous irradiation, from which the rate of reduction in J_{SC} was calculated. The results obtained are shown in Table 6 below.

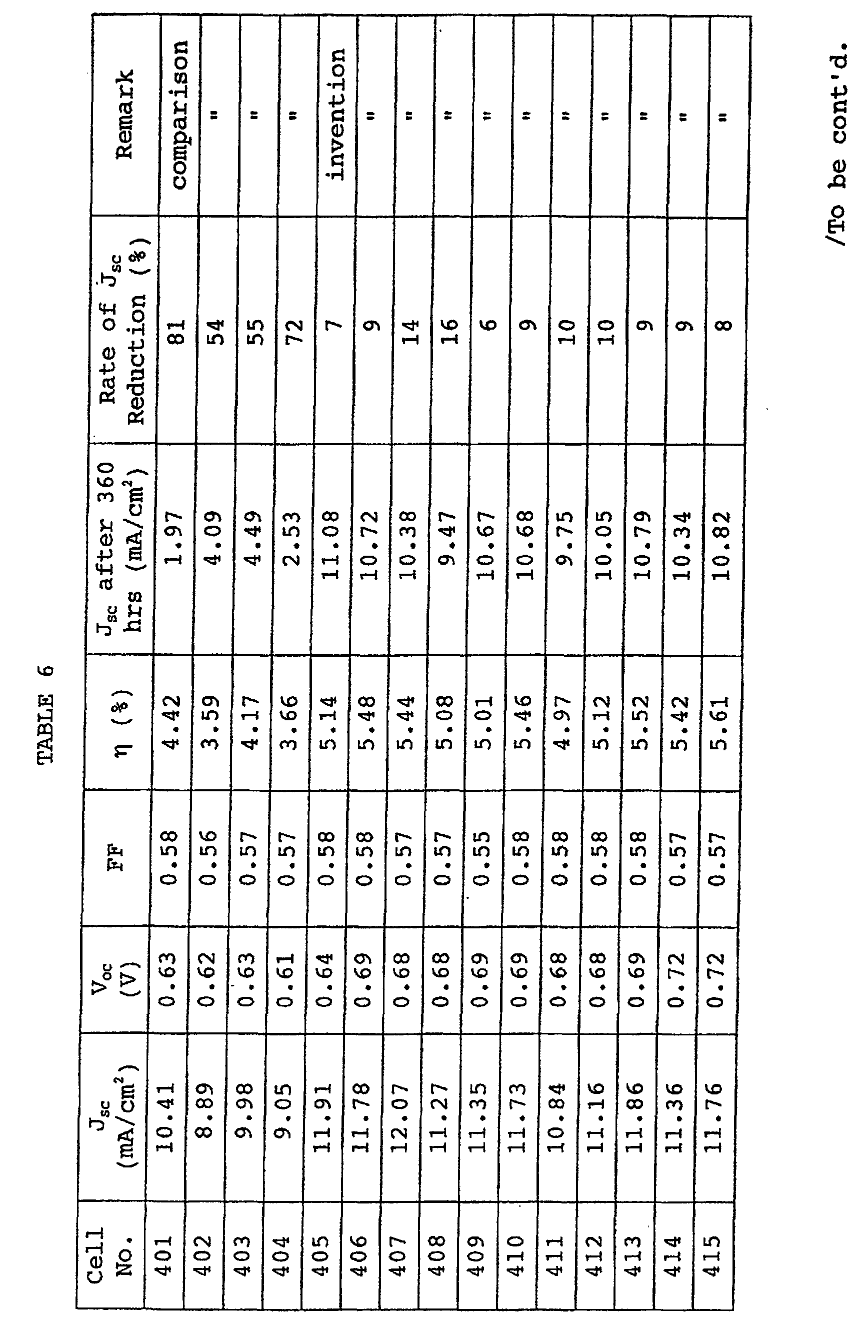

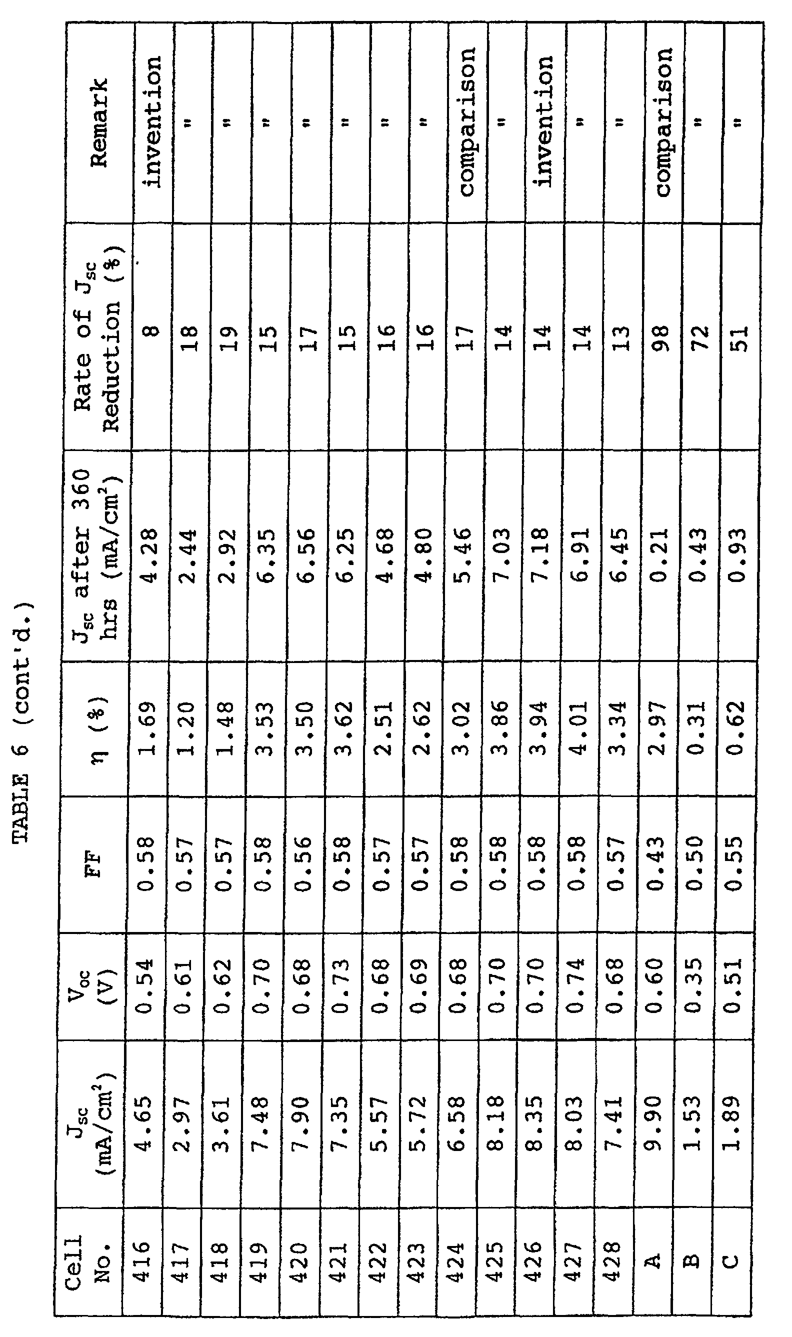

The results in Table 6 prove that the cells of the invention, in which a gel electrolyte containing the high-boiling compound (I) or (II) and the polymer is used, are less susceptible to deterioration of photoelectric conversion characteristics irrespective of the kinds of the sensitizing dye and the supporting electrolyte as compared with the comparative cells using a conventional gel electrolyte containing a relatively low-boiling point organic solvent. It is also ascertained that the cells of the invention are excellent in initial performance such as a short circuit current density and conversion efficiency.

It is also apparent from comparison with cells A, B and C that the cells of the invention have a high short circuit current density and excellent photoelectric conversion characteristics and hardly deteriorate when used for a long period of time.

### EXAMPLE 5

### 1) Preparation of photo-electrochemical cell containing a gel electrolyte

In the organic solvent shown in Table 7 below were dissolved 0.5 mol/l of the supporting electrolyte shown, 0.05 mol/l of iodine, and 0.02 g/l of the gelling agent shown, and the solution was heated at 80°C for 1 hour to prepare an isotropic electrolytic solution. The dye-sensitized TiO₂ electrode substrate prepared above and a Pt-deposited glass substrate were brought into contact with the electrode layer 3 and the Pt deposit layer 6 facing each other. The electrolytic solution was introduced into the gap between the glass substrates by making use of osmotic pressure, followed by cooling to room temperature to gelatinize the electrolyte layer. There were thus obtained photo-electrochemical cells 501 to 546 having the structure shown in Fig. 1.

### 2) Measurement of photoelectric conversion efficiency

The performance of the resulting photo-electrochemical cells was evaluated in the same manner as in Example 4. The results obtained are shown in Table 8 below.

**TABLE 7**

| Cell No. | Dye | Solvent (volume ratio) | Supporting Electrolyte | Gelling Agent | Remark |
|---|---|---|---|---|---|
| 501 | R-1 | NMO | MBIm | G-4 | comparison |
| 502 | R-1 | NMO/PC=1/1 | MBIm | G-4 | " |
| 503 | R-1 | NMO/DME=1/1 | MBIm | G-4 | " |
| 504 | R-1 | AN/NMO=8/2 | MBIm | G-4 | " |
| 505 | R-1 | S-2 | MBIm | G-4 | invention |
| 506 | R-1 | S-11 | MBIm | G-4 | " |
| 507 | R-1 | S-11 | LiI | G-4 | " |
| 508 | R-1 | S-11 | (C₃H₇)₄NI | G-4 | " |
| 509 | R-1 | S-11 | MHIm | G-4 | " |
| 510 | R-1 | S-2 | MBIm | G-3 | " |
| 511 | R-1 | S-2 | MBIm | G-5 | " |
| 512 | R-1 | S-2 | MBIm | G-9 | " |
| 513 | R-1 | S-2 | MBIm | G-10 | " |
| 514 | R-1 | S-2 | MBIm | G-11 | " |
| 515 | R-1 | S-11 | MBIm | G-3 | " |
| 516 | R-1 | S-11 | MBIm | G-5 | " |
| 517 | R-1 | S-11 | MBIm | G-6 | " |
| 518 | R-1 | S-11 | MBIm | G-9 | " |
| 519 | R-13 | S-2 | MBIm | G-4 | " |
| 520 | R-13 | S-11 | MBIm | G-4 | " |
| 521 | R-14 | S-11 | MBIm | G-4 | " |
| 522 | R-16 | S-2 | MBIm | G-4 | " |
| 523 | R-19 | S-11 | MBIm | G-4 | " |
| 524 | (1) | S-2 | (C₃H₇)₄NI | G-4 | invention |
| 525 | (3) | S-14 | LiI | G-4 | " |
| 526 | (5) | S-2 | MHIm | G-4 | " |
| 527 | (5) | S-11 | MBIm | G-4 | " |
| 528 | (26) | S-2 | MBIm | G-4 | " |
| 529 | (26) | S-11 | MBIm | G-4 | " |
| 530 | (29) | S-2 | MBIm | G-4 | " |
| 531 | (29) | S-11 | MBIm | G-4 | " |
| 532 | (32) | S-2 | MBIm | G-4 | " |
| 533 | (32) | S-14 | MBIm | G-4 | " |
| 534 | (37) | NMO/PC=1/1 | MBIm | G-4 | comparison |
| 535 | (37) | AN/NMO=8/2 | MBIm | G-4 | " |
| 536 | (37) | S-2 | MBIm | G-4 | invention |
| 537 | (37) | S-11 | MBIm | G-4 | " |
| 538 | (37) | S-2 | MBIm | G-3 | " |
| 539 | (37) | S-2 | MBIm | G-10 | " |
| 540 | (37) | S-2 | MBIm | G-11 | " |
| 541 | (37) | S-11 | MBIm | G-5 | " |
| 542 | (37) | S-11 | MBIm | G-6 | " |
| 543 | (37) | S-11 | MBIm | G-9 | " |
| 544 | (40) | S-2 | MBIm | G-4 | " |
| 545 | (40) | S-11 | MBIm | G-4 | " |
| 546 | (43) | S-11 | MBIm | G-4 | " |

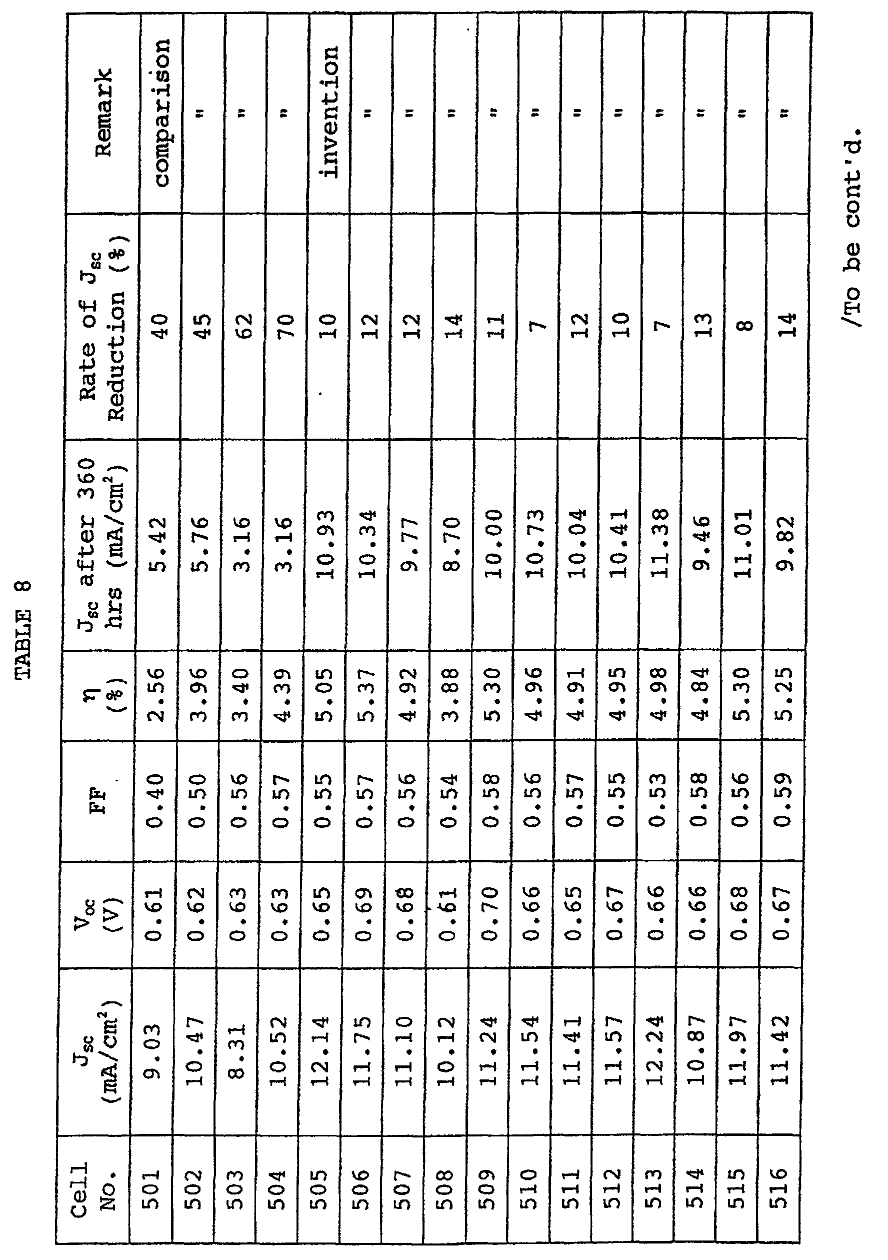

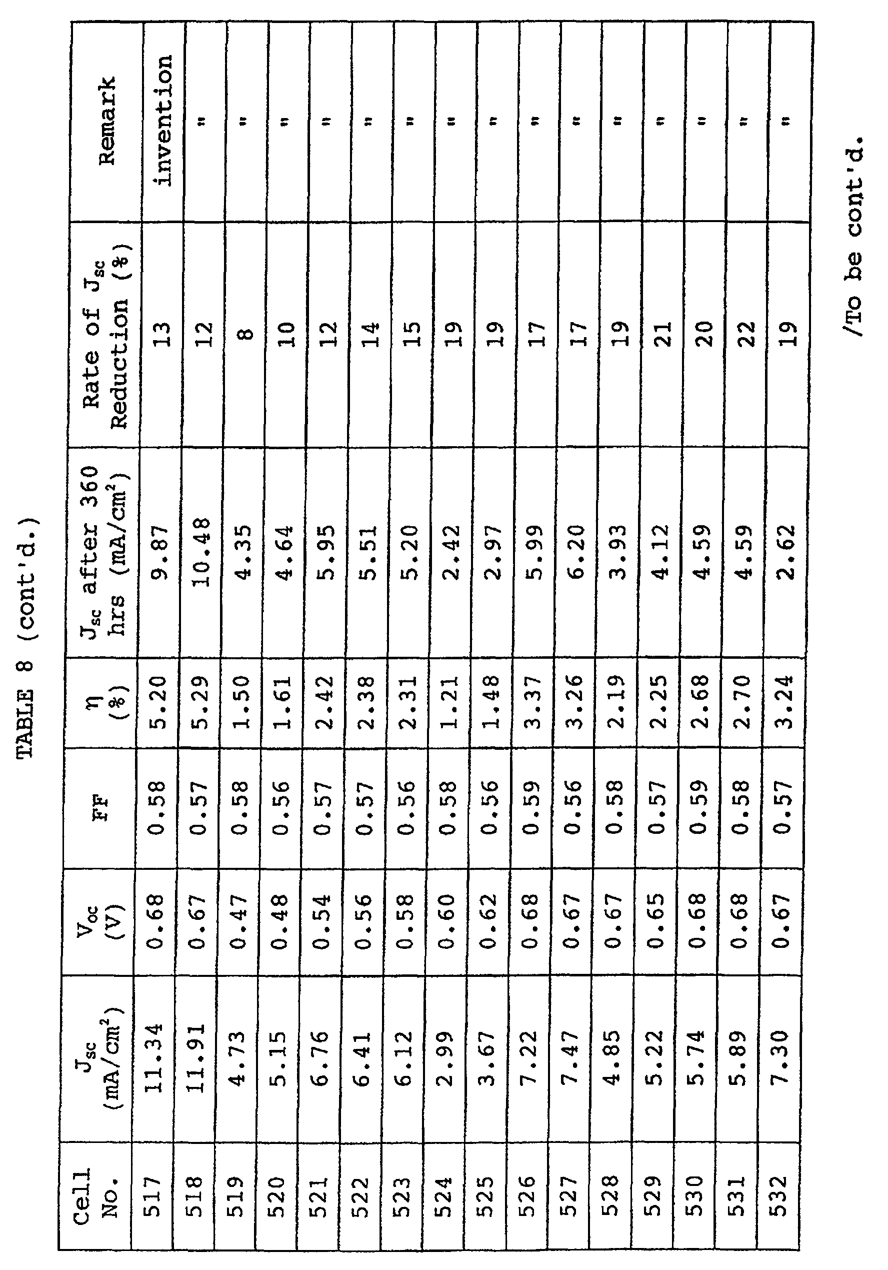

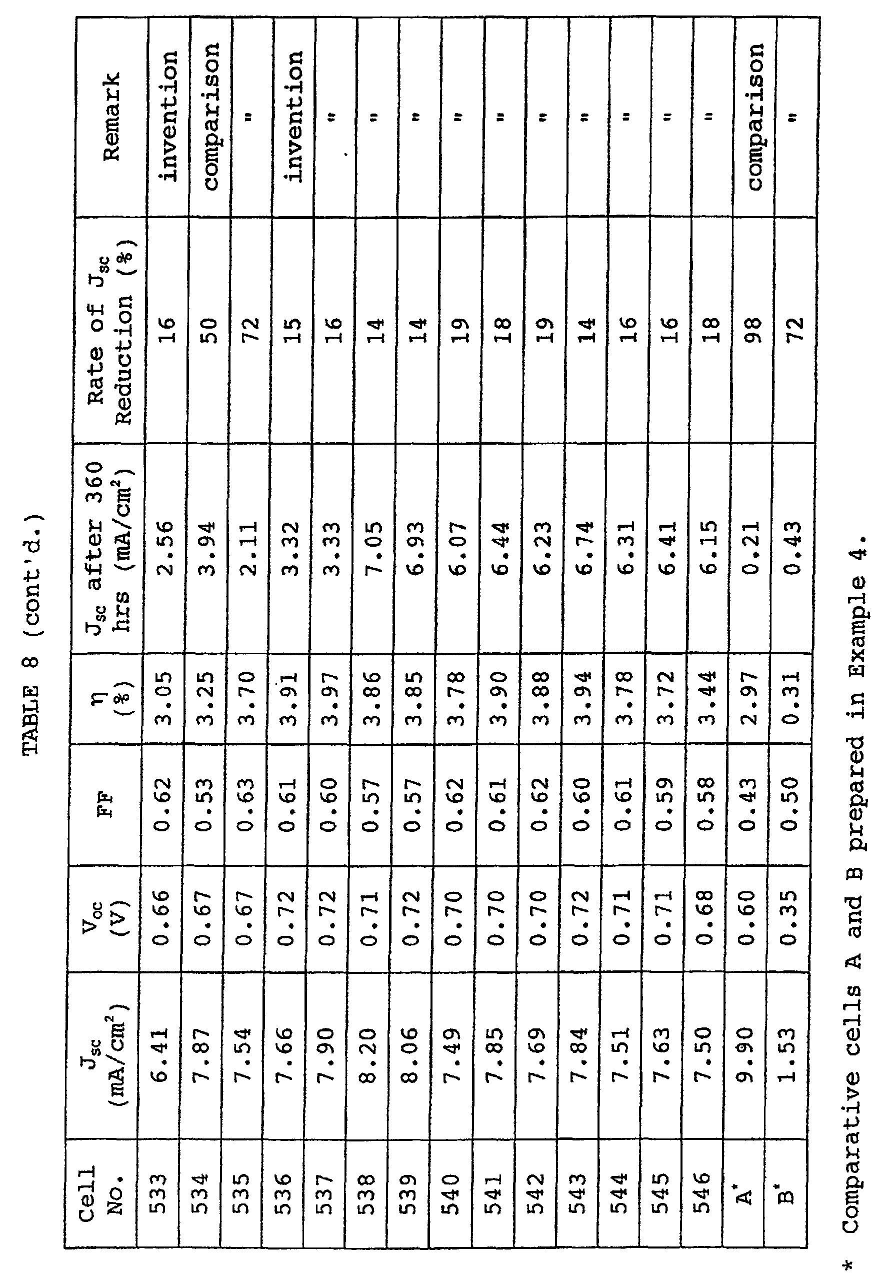

The results in Table 8 prove that the cells of the invention, in which a gel electrolyte containing the high-boiling compound (I) or (II) and the gelling agent is used, are less susceptible to deterioration of photoelectric conversion characteristics irrespective of the kinds of the sensitizing dye and the supporting electrolyte as compared with the comparative cells using a conventional gel electrolyte containing a relatively low-boiling point organic solvent. It is also ascertained that the cells of the invention are excellent in initial performance such as a short circuit current density and conversion efficiency.

Further, comparison with cell A also proves the resistance of the cells of the invention against deterioration of photoelectric conversion characteristics, and comparison with cell B shows that the cells of the invention have a high short circuit current density and excellent photoelectric characteristics.

Therefore, the photoelectric conversion device and photo-electrochemical cell having excellent photoelectric conversion characteristics and less deterioration of the photoelectric conversion characteristics in long-term use can be obtained by the present invention.

## Claims

1. A photoelectric conversion device comprising a semiconductor, an electrically conductive substrate, a counter electrode and an electrolyte containing as a solvent at least one compound selected from a compound represented by formula (I): 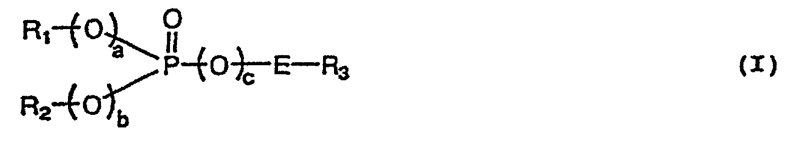 wherein R₁ and R₂, which may be the same or different, each represent an alkyl group, an alkenyl group or an aryl group; R³ represents a cyano group, an alkoxycarbonyl group, an acyloxy group, a carbonamido group, a phosphoric acid group, a phosphono group, a phosphino group, a phosphoryl group, a carbamoyl group, a urethane group, a urea group, a carbonate group, a sulfonamido group, a sulfamoyl group, a sulfoxide group, a sulfone group, a sulfonyl group, a nitro group, an alkoxy group, an aryloxy group or a hydroxyl group; E represents a single bond, an alkylene group, an alkenylene group or an arylene group; and a, b, and c each represent 0 or 1,
and a compound represented by formula (II):
R₄-D-E-R₃ (II)
wherein R³ and E are as defined above; R⁴ represents a heterocyclic group or an alkyl, alkenyl or aryl group having a heterocyclic group; and D represents -O-, -OC(O)- or -OC(O)O-.

2. The photoelectric conversion device as claimed in claim 1, wherein said semiconductor is a dye-sensitized particular semiconductor.

3. The photoelectric conversion device as claimed in claim 1, wherein said semiconductor is contained in a semiconductor-containing layer provided on said electrically conductive substrate, and said electrolyte is contained in an electrolyte-containing layer.

4. The photoelectric conversion device as claimed in claim 1, wherein said electrolyte is a gel electrolyte containing further a gelling agent having a molecular weight of 1,000 or less.

5. The photoelectric conversion device as claimed in claim 4, wherein said gelling agent has at least one amido group in the molecular structure.

6. The photoelectric conversion device as claimed in claim 1, wherein said electrolyte further contains at least one polymer whose main.chain is selected from the group consisting of polyethylene oxide, polypropylene oxide, polyacrylic acid esters, polymethacrylic acid esters, polyvinyl alcohol, polyacrylamide, polyallylamine, polysilane, polyacrylonitrile, polystyrene, polyvinylpyridine, polyvinylimidazole, polyfluoroethylene, and polyvinylidene fluoride, and copolymers comprising two or more of the monomers constituting these homopolymers.

7. The photoelectric conversion device as claimed in claim 6, wherein the main chain of said polymer is polyacrylonitrile or polyvinylidene fluoride.

8. The photoelectric conversion device as claimed in claim 6, wherein said polymer is a crosslinked polymer.

9. The photoelectric conversion device as claimed in claim 8, wherein said crosslinked polymer is represented by formula (III): 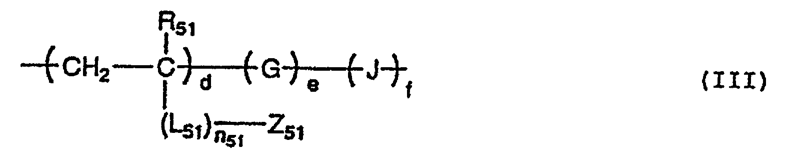 wherein R₅₁ represents a hydrogen atom, an alkyl group or an aryl group; Z₅₁ represents a monovalent organic group having at least one group selected from the group consisting of a heterocyclic group, a cyano group, a carbonate group, -(CH₂CH₂O)ₙ₅₂-R₅₂, and -[CH₂CH(CH₃)O]ₙ₅₃-R₅₃; L₅₁ represents -COO-, -OCO-, -CONR₅₄- or -NR₅₄CO-; n51 represents 0 or 1; R₅₂, R₅₃, and R₅₄ each represent a hydrogen atom, an alkyl group, a cycloalkyl group, an alkenyl group or an aryl group; n52 and n53 each represent an integer of 1 to 30; G represents a repeating unit derived from a compound containing an ethylenically unsaturated group; J represents a repeating unit derived from a compound containing two or more ethylenically unsaturated groups; and d, e, and f represent the weight ratios of the respective repeating units, wherein d is 5 to 99% by weight, e is 0 to 70% by weight, and f is 0.5 to 50% by weight.

10. A photo-electrochemical cell comprising a photoelectric conversion device which comprises a semiconductor, an electrically conductive substrate, a counter electrode and an electrolyte containing as a solvent at least one compound selected from a compound represented by formula (I): 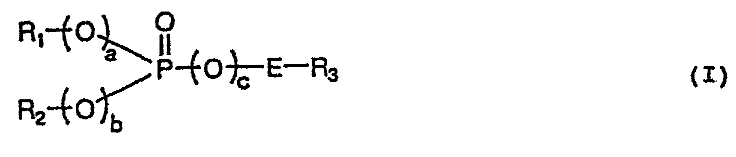 wherein R₁ and R₂, which may be the same or different, each represent an alkyl group, an alkenyl group or an aryl group; R³ represents a cyano group, an alkoxycarbonyl group, an acyloxy group, a carbonamido group, a phosphoric acid group, a phosphono group, a phosphino group, a phosphoryl group, a carbamoyl group, a urethane group, a urea group, a carbonate group, a sulfonamido group, a sulfamoyl group, a sulfoxide group, a sulfone group, a sulfonyl group, a nitro group, an alkoxy group, an aryloxy group or a hydroxyl group; E represents a single bond, an alkylene group, an alkenylene group or an arylene group; and a, b, and c each represent 0 or 1,
and a compound represented by formula (II):
R₄-D-E-R₃ (II)
wherein R³ and E are as defined above; R⁴ represents a heterocyclic group or an alkyl, alkenyl or aryl group having a heterocyclic group; and D represents -O-, -OC(O)- or -OC(O)O-.

11. The photo-electrochemical cell as claimed in claim 10, wherein said electrolyte is a gel electrolyte.

12. The photo-electrochemical cell as claimed in claim 10, wherein said semiconductor is a dye-sensitized particular semiconductor.

## Patentansprüche

1. Photoelektrische Konversionsvorrichtung, umfassend einen Halbleiter, ein elektrisch leitendes Substrat, eine Gegenelektrode und einen Elektrolyt, enthaltend als Lösungsmittel wenigstens eine Verbindung, ausgewählt aus einer Verbindung, dargestellt durch Formel (I): 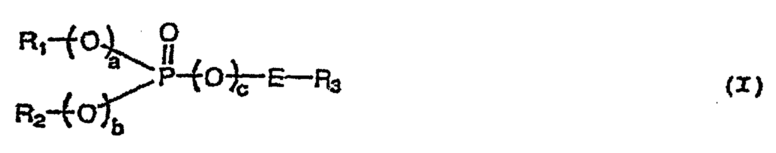 worin R₁ und R₂, welche gleich oder verschieden ein können, jeweils eine Alkylgruppe, eine Alkenylgruppe oder eine Arylgruppe bedeuten; R₃ bedeutet eine Cyangruppe, eine Alkoxycarbonylgruppe, eine Acyloxygruppe, eine Carbonamidogruppe, eine Phosphorsäuregruppe, eine Phosphonogruppe, eine Phosphinogruppe, eine Phosphorylgruppe, eine Carbamoylgruppe, eine Urethangruppe, eine Harnstoffgruppe, eine Carbonatgruppe, eine Sulfonamidogruppe, eine Sulfamoylgruppe, eine Sulfoxidgruppe, eine Sulfongruppe, eine Sulfonylgruppe, eine Nitrogruppe, eine Alkoxygruppe, eine Aryloxygruppe oder eine Hydroxylgruppe; E bedeutet eine Einfachbindung, eine Alkylengruppe, eine Alkenylgruppe oder eine Arylengruppe; und a, b und c bedeuten jeweils 0 oder 1;
und eine Verbindung, dargestellt durch Formel (II):
R₄-D-E-R₃ (II)
worin R₃ und E wie oben definiert sind; R₄ bedeutet eine heterocyclische Gruppe oder eine Alkyl-, Alkenyl- oder Arylgruppe mit einer heterocyclischen Gruppe; und D bedeutet -O-, -OC(O)- oder -OC(O)O-.

2. Photoelektrische Konversionsvorrichtung nach Anspruch 1, worin der Halbleiter ein Farbstoff-sensibilisierter partikulärer Halbleiter ist.

3. Photoelektrische Konversionsvorrichtung nach Anspruch 1, worin der Halbleiter in einer auf dem elektrisch leitenden Substrat bereitgestellten Halbleiter enthaltenden Schicht enthalten ist, und der Elektrolyt in der Elektrolyt enthaltenden Schicht enthalten ist.

4. Photoelektrische Konversionsvorrichtung nach Anspruch 1, worin der Elektrolyt ein Gel-Elektrolyt ist, welcher weiterhin ein Gelierungsmittel mit einem Molekulargewicht von 1.000 oder weniger enthält.

5. Photoelektrische Konversionsvorrichtung nach Anspruch 4, worin das Gelierungsmittel wenigstens eine Amidogruppe in der Molekularstruktur besitzt.

6. Photoelektrische Konversionsvorrichtung nach Anspruch 1, worin der Elektrolyt weiterhin wenigstens ein Polymer enthält, dessen Hauptkette ausgewählt ist aus der Gruppe, bestehend aus Polyethylenoxid, Polypropylenoxid, Polyacrylsäureestern, Polymethacrylsäureestern, Polyvinylalkohol, Polyacrylamid, Polyallylamin, Polysilan, Polyacrylnitril, Polystyrol, Polyvinylpyridin, Polvinylimidazol, Polyfluorethylen und Polyvinylidenfluorid, und Copolymeren, umfassend zwei oder mehrere der diese Homopolymere aufbauenden Monomere.

7. Photoelektrische Konversionsvorrichtung nach Anspruch 6, worin die Hauptkette des Polymer Polyacrylnitril oder Polyvinylidenfluorid ist.

8. Photoelektrische Konversionsvorrichtung nach Anspruch 6, worin das Polymer ein vernetztes Polymer ist.

9. Photoelektrische Konversionsvorrichtung nach Anspruch 8, worin das vernetzte Polymer dargestellt ist durch Formel (III): 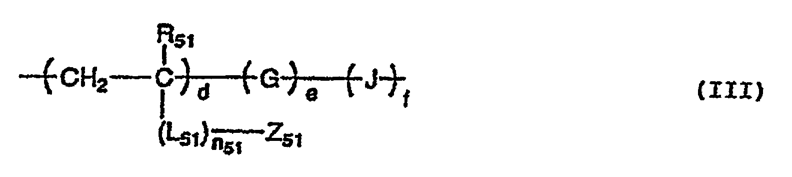 worin R₅₁ ein Wasserstoffatom, eine Alkylgruppe oder eine Arylgruppe bedeutet; Z₅₁ bedeutet eine einwertige organische Gruppe mit wenigstens einer Gruppe, ausgewählt aus der Gruppe, bestehend aus einer heterocyclischen Gruppe, einer Cyanogruppe, einer Carbonatgruppe, -(CH₂CH₂O)ₙ₅₂-R₅₂ und -[CH₂CH(CH₃)O]ₙ₅₃-R₅₃; L₅₁ bedeutet -COO-, -OCO-, -CONR₅₄oder -NR₅₄CO-; n₅₁ bedeutet 0 oder 1; R₅₂, R₅₃ und R₅₄ bedeuten jeweils ein Wasserstoffatom, eine Alkylgruppe, eine Cycloalkylgruppe, eine Alkenylgruppe oder eine Arylgruppe; n₅₂ und n₅₃ bedeuten jeweils eine ganze Zahl von 1 bis 30; G bedeutet eine Wiederholungseinheit, abgeleitet von einer Verbindung, enthaltend eine ethylenisch ungesättigte Gruppe; J bedeutet eine Wiederholungseinheit, abgeleitet von einer Verbindung, enthaltend zwei oder mehrere ethylenisch ungesättigte Gruppen; und d, e und f bedeuten die Gewichtsverhältnisse der entsprechenden Wiederholungseinheiten, worin d 5 bis 99 Gew.-%, e 0 bis 70 Gew.-% und f 0,5 bis 50 Gew.-% beträgt.

10. Photoelektrochemische Zelle, umfassend eine photoelektrische Konversionsvorrichtung, umfassend einen Halbleiter, ein elektrisch leitendes Substrat, eine Gegenelektrode und einen Elektrolyt, enthaltend als Lösungsmittel wenigstens eine Verbindung, ausgewählt aus einer Verbindung, dargestellt durch Formel (I): 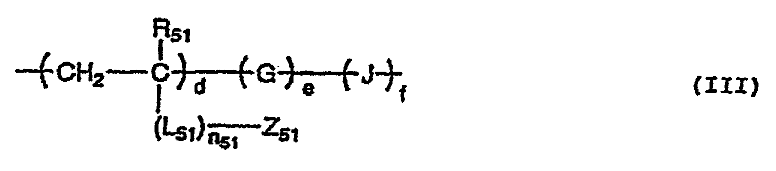 worin R₁ und R₂, welche gleich oder verschieden sein können, jeweils eine Alkylgruppe, eine Alkenylgruppe oder eine Arylgruppe bedeuten; R₃ bedeutet eine Cyanogruppe, eine Alkoxycarbonylgruppe, eine Acyloxygruppe, eine Carbonamidogruppe, eine Phosphorsäuregruppe, eine Phosphonogruppe, eine Phosphinogruppe, eine Phosphorylgruppe, eine Carbamoylgruppe, eine Urethangruppe, eine Harnstoffgruppe, eine Carbonatgruppe, eine Sulfonamidogruppe, eine Sulfamoylgruppe, eine Sulfoxidgruppe, eine Sulfongruppe, eine Sulfonylgruppe, eine Nitrogruppe, eine Alkoxygruppe, eine Aryloxygruppe oder eine Hydroxylgruppe; E bedeutet eine Einfachbindung, eine Alkylengruppe, eine Alkenylengruppe oder eine Arylengruppe; und a, b und c bedeuten jeweils 0 oder 1,
und eine Verbindung, dargestellt durch Formel (II):
R₄-D-E-R₃ (II)
worin R₃ und E wie oben definiert sind; R₄ bedeutet eine heterocyclische Gruppe oder eine Alkyl-, Alkenyl- oder Arylgruppe mit einer heterocyclischen Gruppe; und D bedeutet -O-, -OC(O)- oder -OC(O)O-.

11. Photoelektrochemische Zelle nach Anspruch 10, worin der Elektrolyt ein Gen-Elektrolyt ist.

12. Photoelektrochemische Zelle nach Anspruch 10, worin der Halbleiter ein Farbstoff-sensibilisierter partikulärer Halbleiter ist.

## Revendications

1. Dispositif de conversion photoélectrique comprenant un semi-conducteur, un substrat conducteur électriquement, une électrode de comptage et un électrolyte contenant comme solvant au moins un composé choisi parmi un composé représenté par la formule (I): 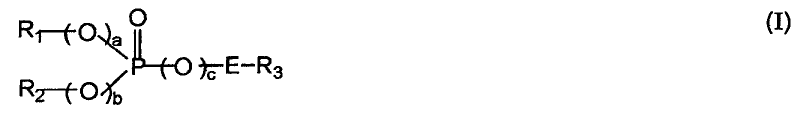 dans laquelle R₁ et R₂, qui peuvent être identiques ou différents, représentent chacun un groupe alkyle, un groupe alcényle ou un groupe aryle ; R³ représente un groupe cyano, un groupe alcoxycarbonyle, un groupe acyloxy, un groupe carbonamido, un groupe acide phosphorique, un groupe phosphono, un groupe phosphino, un groupe phosphoryle, un groupe carbamoyle, un groupe uréthane, un groupe urée, un groupe carbonate, un groupe sulfonamido, un groupe sulfamoyle, un groupe sulfoxyde, un groupe sulfone, un groupe sulfonyle, un groupe nitro, un groupe alcoxy, un groupe aryloxy ou un groupe hydroxyle ; E représente une liaison simple, un groupe alkylène, un groupe alcènylène ou un groupe arylène ; et a, b, et c représentent chacun 0 ou 1,
et un composé représenté par la formule (II):
R₄-D-E-R₃ (II)
dans laquelle R₃ et E sont tels que définis ci-dessus ; R₄ représente un groupe hétérocyclique ou un groupe alkyle, alcényle ou aryle ayant un groupe hétérocyclique ; et D représente -O-, -OC(O)- ou -OC(O)O-.

2. Dispositif de conversion photoélectrique tel que revendiqué dans la revendication 1, dans lequel ledit semi-conducteur est un semi-conducteur particulaire sensibilisé aux colorants.

3. Dispositif de conversion photoélectrique tel que revendiqué dans la revendication 1, dans lequel ledit semi-conducteur est contenu dans une couche contenant un semi-conducteur prévu sur ledit substrat conducteur électriquement, et ledit électrolyte est contenu dans une couche contenant un électrolyte.

4. Dispositif de conversion photoélectrique tel que revendiqué dans la revendication 1, dans lequel ledit électrolyte est un électrolyte en gel contenant en outre un agent de gélification ayant une masse moléculaire de 1000 ou moins.

5. Dispositif de conversion photoélectrique tel que revendiqué dans la revendication 4, dans lequel ledit agent de gélification présente au moins un groupe amido dans la structure moléculaire.

6. Dispositif de conversion photoélectrique tel que revendiqué dans la revendication 1, dans lequel ledit électrolyte contient en outre au moins un polymère dont la chaîne principale est choisie dans le groupe constitué par le poly(oxyde d'éthylène), le poly(oxyde de propylène), des poly(ester d'acide acrylique), des poly(ester d'acide méthacrylique), le poly(alcool de vinyle), le polyacrylamide, la polyallylamine, le polysilane, le polyacrylonitrile, le polystyrène, la polyvinylpyridine, le polyvinylimidazole, le polyfluroréthylène, et le poly(fluorure de vinylidène), et des copolymères comprenant deux monomères ou plus constituant ces homopolymères.

7. Dispositif de conversion photoélectrique tel que revendiqué dans la revendication 6, dans lequel la chaîne principale dudit polymère est le polyacrylonitrile ou le poly(fluorure de vinylidène).

8. Dispositif de conversion photoélectrique tel que revendiqué dans la revendication 6, dans lequel ledit polymère est un polymère réticulé.

9. Dispositif de conversion photoélectrique tel que revendiqué dans la revendication 8, dans lequel ledit polymère réticulé est représenté par la formule (III): 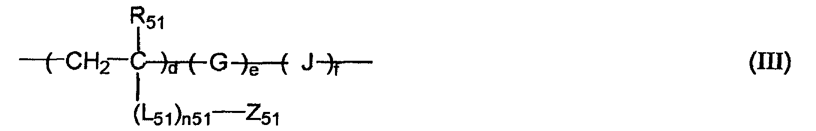 dans laquelle R₅₁ représente un atome d'hydrogène, un groupe alkyle ou un groupe aryle ; Z₅₁ représente un groupe organique monovalent ayant au moins un groupe choisi dans le groupe constitué par un groupe hétérocyclique, un groupe cyano, un groupe carbonate, -(CH₂CH₂O)ₙ₅₂-R₅₂, et -[CH₂CH(CH₃)O]ₙ₅₃-R₅₃; L₅₁ représente -COO-, -OCO-, -CONR₅₄- ou -NR₅₄CO-, n₅₁ représente 0 ou 1 ; R₅₂, R₅₃, et R₅₄ représentent chacun un atome d'hydrogène, un groupe alkyle, un groupe cycloalkyle, un groupe alcényle ou un groupe aryle, n₅₂ et n₅₃ représentent chacun un nombre entier de 1 à 30 ; G représente une unité récurrente dérivée d'un composé contenant un groupe insaturé éthyléniquement ; J représente une unité récurrente dérivée d'un composé contenant deux ou plusieurs groupes insaturés éthyléniquement ; et d, e, et f représentent les rapports pondéraux des unités récurrentes respectives, où d vaut 5 à 99% en poids, e vaut 0 à 70% en poids, et f vaut 0,5 à 50% en poids.

10. Cellule photo-électrochimique comprenant un dispositif de conversion photoélectrique qui comprend un semi-conducteur, un substrat conducteur électriquement, une électrode de comptage et un électrolyte contenant comme solvant au moins un composé choisi parmi un composé représenté par la formule (I): 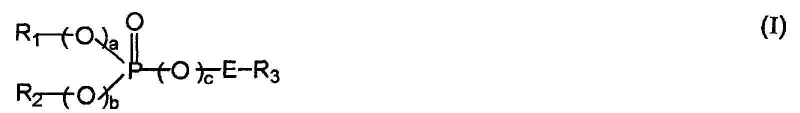 dans laquelle R₁ et R₂, qui peuvent être identiques ou différents, représentent chacun un groupe alkyle, un groupe alcényle ou un groupe aryle ; R³ représente un groupe cyano, un groupe alcoxycarbonyle, un groupe acyloxy, un groupe carbonamido, un groupe acide phosphorique, un groupe phosphono, un groupe phosphino, un groupe phosphoryle, un groupe carbamoyle, un groupe uréthane, un groupe urée, un groupe carbonate, un groupe sulfonamido, un groupe sulfamoyle, un groupe sulfoxyde, un groupe sulfone, un groupe sulfonyle, un groupe nitro, un groupe alcoxy, un groupe aryloxy ou un groupe hydroxyle ; E représente une liaison simple, un groupe alkylène, un groupe alcènylène ou un groupe arylène ; et a, b, et c représentent chacun 0 ou 1,
et un composé représenté par la formule (II):
R₄-D-E-R₃ (II)
dans laquelle R₃ et E sont tels que définis ci-dessus ; R₄ représente un groupe hétérocyclique ou un groupe alkyle, alcényle ou aryle ayant un groupe hétérocyclique ; et D représente -O-, -OC(O) - ou -OC(O)O-.

11. Cellule photo-électrochimique telle que revendiquée dans la revendication 10, dans laquelle ledit électrolyte est un gel électrolyte.

12. Cellule photo-électrochimique telle que revendiquée dans la revendication 10, dans laquelle ledit semi-conducteur est un semi-conducteur particulaire sensibilisé aux colorants.
